(19) Europäisches Patentamt
European Patent Office
Office européen des brevets

(11) **EP 1 382 083 B1**

(12) **EUROPEAN PATENT SPECIFICATION**

(45) Date of publication and mention
of the grant of the patent:
**24.12.2008 Bulletin 2008/52**

(51) Int Cl.:
***H01P 1/213*** *(2006.01)*　　***H03K 17/00*** *(2006.01)*

(21) Application number: **02722535.8**

(22) Date of filing: **02.04.2002**

(86) International application number:
**PCT/IB2002/001030**

(87) International publication number:
**WO 2002/084781 (24.10.2002 Gazette 2002/43)**

(54) **TUNABLE MULTIPLEXER**

ABSTIMMBARER MULTIPLEXER

MULTIPLEXEUR ACCORDABLE

(84) Designated Contracting States:
**AT BE CH CY DE DK ES FI FR GB GR IE IT LI LU
MC NL PT SE TR**

(30) Priority: **11.04.2001 US 283093 P
13.07.2001 US 904631
24.07.2001 US 912753
08.08.2001 US 927732
10.08.2001 US 927136**

(43) Date of publication of application:
**21.01.2004 Bulletin 2004/04**

(73) Proprietor: **Kyocera Wireless Corp.
San Diego, CA 92121 (US)**

(72) Inventor: **TONCICH, Stanley Slavko
San Diego, CA 92131 (US)**

(74) Representative: **Schlee, Alexander Richard
Viering, Jentschura & Partner
Postfach 22 14 43
80504 München (DE)**

(56) References cited:
**EP-A- 0 843 374　　　　EP-A- 1 058 333
WO-A-00/35042　　　　US-A- 5 166 857**

- **KEIS V N ET AL: "20 GHz tunable filter based on
ferroelectric (Ba,Sr)TiO3film varactors"
ELECTRONICS LETTERS, IEE STEVENAGE, GB,
vol. 34, no. 11, 28 May 1998 (1998-05-28), pages
1107-1109, XP006009824 ISSN: 0013-5194**

**Description**

**BACKGROUND**

**Description of Related Art**

Filters, such as bandpass filters, have numerous applications in communications and electronics. For example, in wireless communications a given frequency band must accommodate many wireless users. To accommodate so many users, stringent bandpass filtering requirements must be achieved because of the crowded frequency allocations provided.

At present, wireless handsets use fixed-tuned bandpass filters (BPFs) to meet their filtering specifications. The design of such filters is complicated because they must achieve the lowest possible passband insertion loss (I.L.) - while simultaneously achieving a specified large out-of-band rejection. As a specific example, consider PCS CDMA handsets. The PCS transmit (TX) band should have no more than -3.5 dB I.L. in-band (1850 to 1910 MHz in the U.S.) while having at least a 38.0 dB out-of-band rejection in the receive (RX) band (1930 to 1990 MHz range).

Further, this BPF must meet these specifications with a maximum constraint on height. A typical height constraint in present day handsets, for example, is 4.0 mm or less. To meet these demanding electrical requirements yet possess the smallest possible size and height, high order (> $2^{nd}$ order) fixed-tuned filters constructed from either individual coaxial resonator elements or monoblock structures are usually necessary. In addition, to satisfy out-of-band rejection specifications, a transmission zero is usually required, increasing I.L. at the band edge. Because of variations in ceramics and fabrication tolerances, vendors must individually adjust the characteristics of fixed-tuned filters during their manufacture, driving costs higher.

Moreover, if more than one frequency band were to be supported (e.g., supporting the PCS bands in the U.S., Korea, and India) multiple fixed-tuned BPFs would be necessary, requiring extra switches and introducing additional loss. This is true, even if the power amplifier and low noise amplifier used have sufficient bandwidth to operate over these multiple bands.

A tunable BPF would allow the use of one BPF over several bands, or of a lower order filter to cover a bandwidth wider than a required passband at any particular time. To provide the tunability in a tunable BPF, a component capable of providing a variable capacitance is typically used.

Several structures are presently used to implement a variable capacitor. For example, movable parallel plates have been used for many years as the tuner in home radios. However, such plates are far too bulky, noisy, and impractical for use in modern applications.

Another alternative, the electronic varactor, is a semiconductor device that adjusts capacitance responsive to an applied voltage. Because the varactor is typically noisy and lossy, particularly in applications above 500 MHz, it is ineffective for high-frequency, low-loss applications where high performance is required.

Another alternative, a micro-electro-mechanical-switch (or system) (MEMS) is a miniature switching device that may switch between capacitors responsive to an applied control signal. It, however, is costly, difficult to manufacture and of unproven reliability. In most cases, it provides discrete tuning, in that a system must select between a finite (and small) number of fixed capacitors.

Ferroelectric tunable capacitors are another alternative that has been attempted. Ferroelectric (f-e) materials are a class of materials, typically ceramic rare-earth oxides, whose prominent feature is that their dielectric constant ($\kappa$), and as a consequence, the electric permittivity ($\in$) changes in response to an applied slowly varying (DC or low frequency) electric field. The relationship of the dielectric constant ($\kappa$) and the electric permittivity ($\in$) of a material is given as follows:

$$\in \ = \ \kappa \in_0$$

where $\varepsilon_0$ is the electric permittivity of a vacuum. At present, there are several hundred known materials that possess f-e properties. In a typical f-e material, one can obtain a range in $\kappa$ by a factor of as much as approximately 3:1. The required DC voltage to generate such a change in $\kappa$ depends on the dimensions of the f-e material over which a DC control voltage is applied. As a result of their variable dielectric constant, one can make tunable capacitors using f-e materials, because the capacitance of a capacitor depends on the dielectric constant of the dielectric proximate the capacitor conductors. Typically, a tunable f-e capacitor is realized as a parallel plate (overlay), interdigital (IDC), or a gap capacitor.

In known f-e variable capacitors, a layer of an appropriate f-e material, such as barium strontium titanate, $Ba_xSr_{1-x}TiO_3$ (BSTO) is disposed adjacent to one or both conductors of a capacitor. Depending upon the strength of the electric field applied to the f-e material and the intrinsic properties of the f-e material selected, the capacitance changes. Typically, below the Curie temperature, $T_c$, of the f-e film, the f-e material is in the ferroelectric state and will exhibit hysteresis in its response to a changing electric field. Above $T_c$, f-e material is in the paraelectric state and will not exhibit hysteresis. Thus, one generally picks an f-e material whose $T_c$ is lower than the expected operating temperature so as to operate in the paraelectric state, avoiding the hysteresis effects of the ferroelectric state.

However, conventional f-e variable capacitors have proven to be too lossy for use in insertion-loss-sensitive applications such as handsets. Moreover, these devices often perform unpredictably, preventing optimal design, construction, and use of f-e tunable filters.

Duplexers are used in CDMA technology to separate the Tx and the Rx frequencies into their respective signal paths. Duplexers typically comprise two bandpass filters. Each filter selects either the Tx or the Rx frequency signal to be passed. The filters are coupled at one end, forming a common port. This common port is typically coupled to an antenna or a diplexer for sending transmit signals and receiving receive signals.

Strict insertion loss and out-of-band rejection requirements are the primary requirements that influence the design of duplexers for use in loss sensitive applications, such as, for example, in wireless handsets. Other electrical and mechanical specification must also be satisfied, such as, for example, size and height requirements.

Accordingly, there is a need in the art for improved tunable f-e filters capable of providing a tuning range over a desired frequency range with low I.L. and high out-of-band rejections and methods for designing the same. These filters could then be used to make tunable duplexers.

A tunable multiplexer according to the preamble portion of claim 1 is known from document EP-A-0 843 374. The known circuit owns a first signal filter and a second signal filter, each of the filters comprising tunable ferro-electric capacitors.

## SUMMARY

In CDMA wireless handsets, strict insertion loss and out-of-band rejection requirements generally mandate high order (> $3^{rd}$ order) filters for use in duplexers. The in band insertion loss requirements generally apply over a frequency broader than that used for operation at any given time. This means that a fixed tuned filter for use in a duplexer must have a broader passband than would a tunable filter used by tuning over that same passband. Because the tunable filter could have a smaller (tunable) passband, it could be lower order (taking up less space) or it could have less insertion loss, or both.

This is only true though, if adding tunability does not increase the insertion loss of the duplexer too much. The above-mentioned problems are solved by a tunable multiplexer according to claim 1. The invention provides for a ferro-electric tunable capacitor and capacitor and resonator circuit that makes a duplexer tunable, while maintaining low insertion loss.

Thus, a low insertion loss tunable duplexer which is smaller and has less insertion loss than a fixed tuned bandpass filter that could cover the same passband is provided. The space savings in a wireless handset can be used to provide other desired functions and properties, or it can be used to simply reduce the size and weight of the handset. Additionally, the savings in insertion loss result in a longer talk time and battery life.

## BRIEF DESCRIPTION OF THE DRAWINGS

FIG. 1a is a plan view of a ferro-electric gap capacitor.

FIG. 1b is a cross-sectional view of the ferro-electric gap capacitor of FIG. 1a taken along line A.

FIG. 2a is a plan view of a ferro-electric overlay capacitor, along with an accompanying DC blocking capacitor.

FIG. 2b is a plan view of the first metal layer in the overlay capacitor of FIG. 2a.

FIG. 2c is a cross-sectional view of the overlay capacitor of FIG. 2a taken along line B in Fig. 2a.

Figure 3 illustrates an enlarged view of area C in Figure 2a.

Figure 4 is a plan view of a ferro-electric interdigital capacitor.

Figure 5 is a schematic of a resonator coupled to a tunable ferro-electric capacitor.

Figure 6 is a schematic of a single pole tunable filter.

Figure 7 is a planar circuit implementation of the single pole filter of Figure 6

Figure 8a is a schematic of a double pole tunable filter having a ferro-electric capacitor configured to compensate for frequency response distortions induced by tuning.

Figure 8b is a schematic of a double pole tunable filter having a two ferro-electric capacitors configured to compensate for frequency response distortions induced by tuning.

Figure 9 is a schematic of a divider network and direct current voltage source used to tune the two ferro-electric capacitors configured to compensate for frequency response distortions induced by tuning shown in Fig. 8b.

Figure 10 shows one implementation of the divider network shown in Fig. 9.

Figure 11a is a plan view of the tunable filter shown in Fig. 8a.

Figure 11b is a cross-sectional view of the tunable filter shown in Fig. 11a, taken along line D.

Figure 12 is a schematic of a tunable duplexer.

Figure 13 is a frequency response graph of a tunable duplexer with chip capacitor input and output coupling and f-e capacitor Q = 180.

Figure 14 is a frequency response graph of a.tunable duplexer with chip capacitor input and output coupling and f-e capacitor Q = 450.

Figure 15 is a frequency response graph of a tunable duplexer with integrated gap capacitor input and output coupling and f-e capacitor Q = 180.

Figure 16 is a frequency response graph of a tunable duplexer with integrated gap capacitor input and output coupling and f-e capacitor Q = 450.

Use of the same reference symbols in different figures indicates similar or identical items.

## DETAILED DESCRIPTION

In designing a tunable bandpass filter (BPF) for use and application in electronic signal processing systems, such as, for example, communications systems, one must usually meet or exceed both out-of-band rejection and pass band insertion loss (I.L.) requirements as well as size, weight and other mechanical, environmental and electrical requirements imposed on fix-tuned BPF's.
Thus, for a tunable BPF to be a commercially viable replacement for a fixed-tuned BPF, its performance should exceed that of the fixed-tuned BPF it is replacing in terms of most or all of the electrical and mechanical requirements. In demanding applications such as wireless handsets, passband I.L. must be minimized to prevent placing an even greater burden on other components in the handset. If a tunable BPF has I.L. greater than the fixed-tuned BPF it is to replace, the added I.L. may prove to be too great a burden on the overall system performance. The added burden would usually be greatest on active devices like amplifiers. The amplifiers would have to have greater gain and power output to overcome the effects of increased passband loss over that of existing fixed bandwidth filters.
Many definitions of what defines a "pass band" may be used. Typically the pass band is defined by the points where the bandpass filter response falls to 3.0dB below the midband, or band-center insertion loss (I.L$_0$.). However, any fixed filter response can be used to define the pass band. Higher order (more resonators) bandpass filters are typically required to meet a specific out-of-band rejection requirement. But increasing the filter order will increase the I.L$_0$. A useful basic relationship between filter order and I.L$_0$. is given by the following equation:

$$I.L_0. = (4.34 * Q_l / Q_u) * \sum_{i=1}^{N} g_i \qquad (1)$$

where N is the filter order,

$Q_u$ is the unloaded Q of the resonators used,

$Q_1 = f_0/BW$ (BW is the 3 dB passband and $f_0$ is the midband frequency), and

$g_i$ are the filter element values for a given topology (Chebyshev vs. Butterworth).

Generally, a Chebyshev response is preferable as it gives a steeper rejection response compared to that given by a Butterworth filter for a given filter order. Additionally, increasing the ripple in a Chebychev BPF further increases out of band rejection. As can be seen from equation (1), for a given filter order N, a larger passband results in lower $I.L_0$. as $Q_l$ will decrease as BW increases. This lower $I.L_0$. comes at the expense of decreased selectivity. To regain selectivity, the filter order N must be increased, at the expense of $I.L_0$. One of ordinary skill in the art of bandpass filter design will appreciate that equation (1) represents the best one can do for a given system requirement and filter order. Using a higher order filter (more resonators of a given unloaded Q) quickly increases $I.L_0$., because the $g_i$ values get progressively larger in magnitude, even as there are more of them to sum (increased N). Note that equation (1) neglects implementation losses, which further increase $I.L_o$, especially as the band edge is approached.

It can be seen from equation (1) that using a first or second order bandpass filter reduces $I.L_0$. At these lower orders, both the number (N) of the $g_i$ coefficients decreases as well as the magnitudes of the $g_i$. These low-order filters should be constructed from resonators that have the lowest loss (highest $Q_u$) so as to give the minimum $I.L_0$. possible. The resulting 1st or 2nd order bandpass filter will always have lower $I.L_0$. for a given resonator size and type (i.e., for a given $Q_u$) than the comparable fixed-tuned bandpass filter design of higher order. Tunability allows the low order narrowband BPF able to replace a wider band, fix-tuned BPF. A tunable narrowband low order BPF can cover the entire band of interest, overcoming the limitation of having a narrow bandwidth. This assumes that the desired channel (information) bandwidth is narrower than the total system bandwidth.

Tunable BPFs have the best chance of replacing fixed-tuned BPFs in those cases where the fixed-tuned BPF covers a system bandwidth that is greater than that required for transmission or reception of a single channel. For example, a fixed-tuned BPF in a handset for operation in the U.S. CDMA PCS band covers such a BW. It will be understood that this is also true of U.S. cellular CDMA and many other standards. The techniques, methods and devices taught herein are applicable to many standards besides U.S. CDMA PCS. U.S. CDMA PCS is discussed as an example only.

In the U.S. PCS band, 60 MHz is allocated for Tx (1850 to 1910 MHz) and 60 MHz for Rx (1930 to 1990 MHz). The CDMA standard is a full duplex system, meaning the handset must simultaneously transmit and receive. To accomplish this, a duplexer filter is needed to separate the bands and prevent interference. While the PCS band is 60 MHz wide, the individual CDMA channel is only 1.25 MHz wide. Current system architecture, however, forces CDMA PCS bandpass filters and multiplexers (including duplexers) to have a BW ≥ 60 MHz as the system must allow for and accommodate operation of any 1.25 MHz channel in any region of the 60 MHz band.

A tunable PCS band filter could alter this situation by meeting the worst case rejection specifications while providing a lower order BPF of simpler topology that occupies a smaller physical area. Such a lower order filter would necessarily provide lower $I.L_0$. by virtue of equation (1).

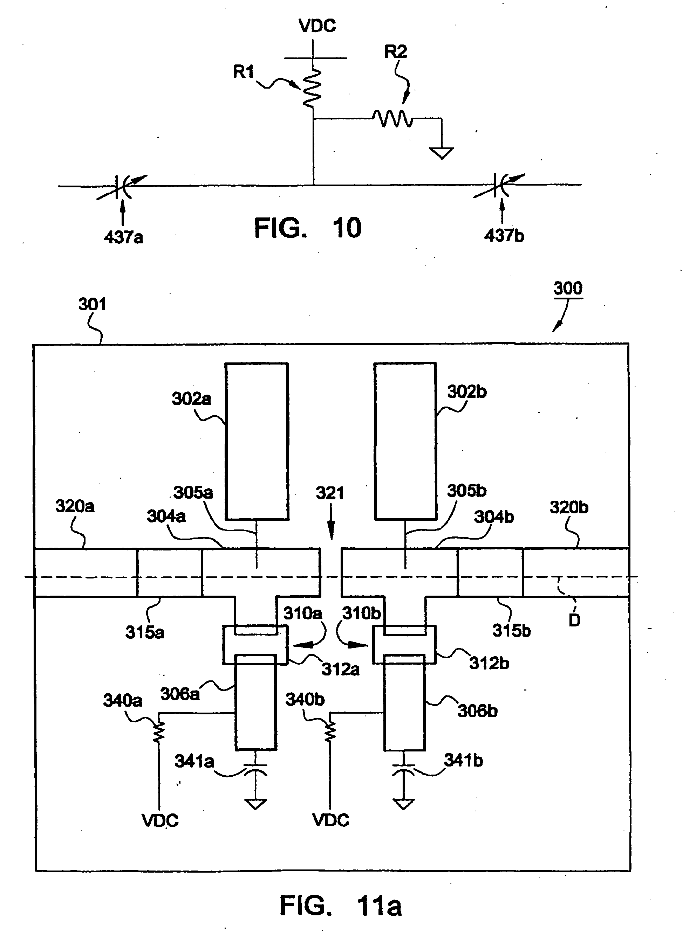

To effectively replace a high-order fixed-tuned BPF with a low-order tunable BPF, three factors should be considered. First, the bandwidth (i.e. $Q_l$) of the low-order BPF and the chosen topology must be such that the worst case rejection specification is met. Because $Q_l = f_0/BW$, as the 3dB bandwidth (BW) decreases, the I.L. increases. Thus, if BW is too small relative to $f_0$, the resulting BPF will have an unacceptably high I.L., requiring a tradeoff between BW and I.L. For practical designs, a low-order tunable BPF should have the lowest possible I.L. consistent with meeting the worst-case required rejection. Some topologies are preferred in that they naturally provide a low side (below the transmission band) zero or a high side (above the transmission band) zero. A topology such as that shown in Fig. 10 is capable of providing a lower passband I.L. because the BPF $Q_l$ is smaller (because bandwidth is greater) or the ripple (manifested in the $g_l$ terms of the corresponding Chebyshev BPF) is lower or both. The transmission zero provides the extra required rejection over a certain frequency range.

Second, the low-order tunable filter must be tunable to cover the entire BW, just as with a fixed-tuned filter. Finally, the tunable capacitor used within the low-order tunable filter should be of sufficiently low loss so the resulting filter has an I.L. that meets or exceeds specifications. Although a tunable 1st or 2nd order bandpass filter will be of minimum added loss compared to a higher order (N > 2) fixed-tuned bandpass filter design, the tunable component (variable f-e capacitor) must have a fast tuning mechanism and be tunable to cover the entire bandpass range, using the available tuning voltage.

The total loss of a capacitor, $L_t$, whether tunable or not, is given by a ratio of its dissipated to stored energy, where the energy is stored in the electric field and dissipated in resistance, i.e., $L_t$ = (dissipated energy)/(stored energy).

The inverse of this loss is the quality factor, Q. For a capacitor, $L_t$ may be given by the quantity ($\omega * R_s * C$), where $\omega$ is the frequency in radians, $R_s$ is the total series resistance of the capacitor, and C is the capacitance.

The importance of determining the total loss given by an f-e capacitor in a resonant circuit can be seen from the following equations: $L_c = 1/Q_c$ and $1/Q_T = 1/Q_c + 1/Q_u$, where,

Lc = the loss of the capacitor;

$Q_T$ = the total Q of the f-e capacitor and the resonator or inductor combined;

$Q_c$ = the Q of the capacitor; and

$Q_u$ = the Q of the unloaded resonator or alternatively, the Q of an inductor used to create a parallel resonant circuit.

As $Q_c$ increases, it will affect the $Q_T$ less and less. If $Q_c$ is infinite, it has no affect on $Q_T$. For practical purposes, this is also true if $Q_c$ is approximately $10*Q_u$. The converse is true too. As $Q_u$ becomes higher and higher relative to $Q_c$, $Q_u$ has less and less effect on $Q_T$. In either case, the highest practical $Q_c$ is desired.

For a useful example for use in the PCS band, for a 1.0 pF tunable capacitor to have a $Q_c = 250$ at 2.0 GHz requires that $R_s$ be .32 $\Omega$ (ohms). To minimize loss (obtain a low $R_s$), requires an accounting of all loss mechanisms present and an elimination of these loss mechanisms if possible.

For f-e devices, the total loss is governed by summing each source contribution as follows:

$$L_t = L_{geom} + L_{attach} + L_{metal} + L_{sub} + L_{rad} + L_{meas} + L_{f-e};$$

where $L_{geom}$ is derived from the topology of the capacitor,

$L_{attach}$ is loss due to device attachment,

$L_{metal}$ is the total metal loss,

$L_{sub}$ is the base substrate loss (if present),

$L_{rad}$ is the radiation loss, both desired and undesired,

$L_{meas}$ is the total loss arising from measurement errors, and

$L_{f-e}$ is the f-e loss tangent.

This loss allocation can first be used to obtain an accurate value of $L_{f-e}$ (or f-e tan $\delta$) at the desired operating frequency in the manner in which the f-e capacitor will be used. To correctly derive $L_{f-e}$, one must eliminate or constrain all of the other loss contribution sources just described. For example, $L_{geom}$ will vary according to topology, being best for an overlay capacitor, worse for a gap capacitor, and much worse for an IDC capacitor. Although this loss can be reduced and controlled, it is inherent to a device. Consequently, the choice of topology for a given f-e capacitor will affect the best possible $Q_c$ attainable from the f-e capacitor. Electromagnetic (EM) software can establish a baseline loss for a desired geometry, assuming a lossless f-e film. This baseline loss represents the best (lowest) loss for a given geometry.

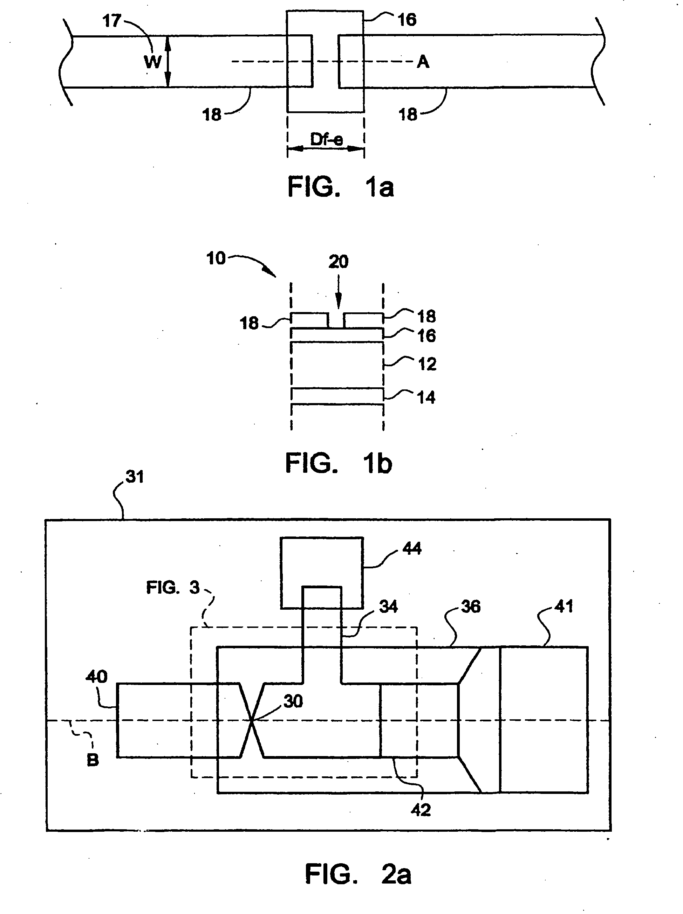

In general, a gap capacitor is easiest to fabricate. An IDC is next easiest, and an overlay capacitor is hardest of these three. Compared to an IDC, the gap capacitor will have a better Q but lower capacitance per unit cross section (W in Fig. 1a). The IDC's capacitance is greater due to the use of a number of fingers per unit cross section. For many communication filter applications, however, large capacitance ($C \geq 4.0$ pF) is not needed. Thus, a gap capacitor often can provide adequate capacitance. The inherently high value of $\kappa$ for most f-e films helps provide relatively high capacitance per unit cross section, W, compared to a conventional gap capacitor.

$L_{attach}$ arises from discrete device attachment techniques, including, for example, solder, silver paint, or wire bonding. These attachment losses may be large and unpredictable. The lowest losses are achieved by direct fabrication of the f-e capacitor to the resonator or other RF circuitry, thus minimizing if not eliminating this loss component.

The inherent loss of a stand-alone f-e capacitor is of little consequence. What is of much greater consequence is any added loss arising from the attachment of the f-e capacitor to a circuit. Even if the f-e capacitor were lossless, should a large loss connection be used, the overall effect is that of a lossy f-e device. For example, if a $Q \geq 250$ at 2.0 GHz is desired for a capacitance of 1.0 pF, then the total series resistance $R_s$ must be $\leq 0.32$ ohm. Any additional loss will thus further reduce the Q of this capacitor. That this additional loss is external to the actual capacitor is irrelevant. Even unavoidable loss mechanisms, such as those due to mounting, for example, lower the effective Q of the capacitor from the perspective of its effect on the system.

For minimum added loss, the connection between the f-e capacitor and the resonator should provide the lowest added resistance. Thus, the electric currents and charges associated with the f-e capacitor should see a minimum added loss. Conventional bonding or mounting techniques, such as (but not limited to) soldering, wire bonding or silver paint or paste do not provide for such a low loss, controllable bond.

The added, unpredictable loss arising from the use of such bonding methods degrade the realized Q regardless of whether or not the f-e capacitor is being used for resonator tuning purposes or characterization of an f-e film. Thus, for best performance (lowest loss) the f-e capacitor structure should be directly fabricated onto or with the resonator it is meant to tune or onto other essential RF circuitry. Only by direct fabrication can there be a minimum loss transition for electromagnetic (EM) sources (currents) from the f-e tuning elements to the resonator. The desirable effects of direct f-e capacitor fabrication onto or with a resonator can be enhanced by the lack of sharp corners or transitions.

Factors for $L_{metal}$ include the surface roughness (SR) of the metal, metal thickness as compared to skin depth, $\delta s$, and conductivity. SR may be effectively eliminated as a factor if SR is less than aproximately 10 micro inches root mean square (rms) for operating frequencies in the L and S band (1-4 GHz). The metal thickness may be reduced as a factor if the thickness is $1.5\delta s$ or greater, or effectively eliminated if the thickness is $\geq 5\delta s$. For electrode contacts, metal thickness ($t_m$) can be approximately $1.5\delta s$. For the case of electromagnetic resonators, where a travelling or standing wave must be supported, i.e., where the metal in question extends for an appreciable fraction of a wavelength (about 10% or greater), the metal thickness should be closer to about $5\delta s$ or greater.

Conductivity is best for Au, Cu, or Ag. Thus, $L_{metal}$ can be reduced and controlled, but not eliminated as a factor. Its effect, however, can be calculated by expressions well known to those skilled in the art, or by using line calculator tools available in commonly used circuit simulators, such as Eagleware or Touchstone. Further, precise fabrication control can bound geometric variations in $L_{metal}$.

The loss contribution represented by $L_{sub}$ may be minimized by choosing a low loss substrate with a loss tangent less than 0.001 and preferably less than 0.0005 at the operating frequency of interest. Suitable materials include >99% pure alumina, a best current choice for loss/cost benefits. Sapphire or MgO are better than alumina in that they have lower loss tangents, but they are more expensive. All these materials will accept f-e thin films without buffer layers and have a surface roughness that is acceptable with little or no further polishing. Semiconductor substrates are poor choices because of their relatively high conductivity. In addition to the factors of loss tangent, surface roughness and price, suitable substrates should not be brittle, can be fabricated as larger area wafers, and can be easily metallized without extensive pre-processing.

Separating out $L_{sub}$ from the total loss of a composite substrate (f-e film plus substrate) can be achieved by using EM field or circuit simulation software. For example, Sonnet, Momentum, or IE3D may be used. Thus, $L_{sub}$ can be reduced significantly and calculated precisely.

$L_{rad}$ can be eliminated by proper shielding and design, and so is typically not a factor. It should be noted that a wide variety of filters, especially planar filters such as combline or hairpin, depend upon radiative coupling to achieve their desired performance. In these cases, one should ensure that the unwanted, stray coupling is reduced, if not eliminated.

$L_{meas}$ can add significantly to the circuit loss error because small, added loss significantly reduces the measured Q of the device-under-test (DUT) or system thus obscuring the intrinsic Q of the DUT. The conventional method for measuring dielectric constant and loss tangent in a material is the cavity perturbation technique, which is well known to anyone skilled in the art. At L-band, however, the size of the cavity becomes quite large. When characterizing thin films (as opposed to bulk) with film thickness $\leq 1.5\ \mu m$, such as f-e films, the problem becomes very difficult as measurement errors can be severe. Furthermore, one should characterize an f-e capacitor (or filter) in a manner most similar to how it will be used. Thus, the preferred way to characterize f-e compounds or films is by microstrip resonator techniques.

For the purposes of determining f-e film characteristics and characterizing f-e capacitors, microstrip techniques are preferred to, for example, stripline or other volumetric techniques for f-e film characterization for the following reasons:

1) Microstrip circuits are planar systems with no top cover, so no bonding of hard substrates as top covers is required. So there is also no need for continuity of ground planes (top to bottom) as needed in a stripline, for example.

2) Preferably gap capacitors, and alternatively, IDC's, can be readily fabricated and measured.

3) A large body of knowledge exists as to the characterization of microstrip resonators.

4) No complex fixturing or fabrication or both are needed as are required for dielectric cavities, for example.

One should measure high-Q circuits using resonator techniques because broadband measurement may not accurately resolve sub-ohm resistive losses at RF/microwave frequencies with any accuracy. For the same reason, LRC meters are not a good choice.

Measurement at radio frequency is required to correctly obtain Rs and consequently Q, for an f-e capacitor, since low frequency measurement, especially those below about 100 MHz, is dominated by a large parallel resistance, Rp, that shunts the capacitance in question. The dominance of Rp, along with the relatively small values of the capacitance in question ($\leq$ 4.0 to 5.0 pF) prevents reliable Q (and therefore Rs) measurement at low frequencies. -

When used to measure losses, wafer probe stations must be carefully used because it is difficult to calibrate out resistive and inductive loss at RF/microwave frequencies. Probe tips along with their ground connections are also sensitive to placement on the DUT as well as the pressure used to apply them. As a consequence, it is better to use a resonant test circuit that allows for direct measurement of the desired parameters in a way that does not require individual device loss measurements.

Thus, for measurements on resonant circuits, a network analyzer is the preferred choice. To minimize measurement loss and attain the most accurate measurement, one should calibrate out loss to the DUT, perform a full two port calibration of the network analyzer, and use averaging for calibration and measurement. Finally, proper analysis of the measured data, such as that outlined in "Data Reduction Method for Q Measurements of Strip-Line Resonators," IEEE Transactions in MTT, S. Toncich and R.E. Collin, Vol. 40, No. 9, Sept. 1992, pp. 1833-1836, is required to accurately extract the Q, or loss, of the capacitor under test.

Using the results of above discussion to minimize, eliminate, or bound each of the foregoing losses, the total loss may be re-expressed as:

$$L_t = L_{geom} + L_{metal} + L_{f-e} + \Delta L_{misc}$$

As discussed above, both $L_{geom}$ and $L_{metal}$ may be quantified and removed analytically. $L_{geom}$ can be determined from an accurate electromagnetic simulation of the circuit based on a lossless f-e material assumption. $L_{metal}$ can be determined using the expressions for metal loss assuming conductivity, SR (if applicable), and skin depth. The final term, $\Delta L_{misc}$, represents a combination of the incomplete removal of the other loss mechanisms or from the finite bounds on or incomplete removal of $L_{metal}$ and $L_{geom}$ or both. As such it represents an irreducible error term. For accurate measurements of f-e film/component properties, it should be minimized and bounded, as described in the preceding sections.

Finally, to reduce the effect of $L_{f-e}$ to a minimum one must use selective f-e film deposition to place the f-e film only in regions where it is needed for tuning and nowhere else.

The process of accounting for all loss mechanisms and eliminating or bounding these losses not only determines f-e loss but also establishes correct design guidelines for low-loss tunable filters. Knowledge of $L_{f-e}$ gives the designer a baseline for the f-e film that is necessary for doing any type of optimum design using f-e films. This knowledge is necessary if one is to effectively trade-off loss tangent for tunability, for example. In short, accurate fabrication and measurement techniques result in consistent f-e film loss characterization and application.

Given the above techniques for minimizing loss, preferred embodiments for the three types of f-e capacitors may now be discussed. It will be appreciated, that although these designs are for use in the L band (1-2 GHz), the teachings of the present invention may be used to design f-e capacitors for other frequency bands.

A preferred f-e tunable gap capacitor 10 is shown in Figure 1a and 1b for use in the cellular band (800 to 1000 MHz) and the L-band (1-2 GHz) for wireless handsets. The gap capacitor 10 is preferably formed on a $\geq$ 99% pure, 0.5 to 1.0 mm thick alumina, MgO, or sapphire substrate 12, having an SR less than a 5.0 micro inch RMS. Alternatively, the gap capacitor can be directly patterned on the front or rear face or a side-wall of any number of resonators structures. Examples are coaxial, monoblock or stripline resonators. Such a capacitor should be fabricated as close to its point of electrical connection to the resonator as possible.

The substrate 12 may have a metal ground plane 14 depending on other requirements. However, the preferred embodiment is without a ground plane to minimize stray capacitance. Preferably, a f-e layer 16 of approximately 0.1 to 2.0 microns in thickness formed of BSTO or other suitable or desirable f-e material for maximum capacitance and tuning range is deposited on the substrate 12. More preferably, layer 16 is 0.5 to 1.0 microns in thickness. The Ba/Sr fraction, doping, alloying, mixing with other components, and/or annealing determine the desired tuning characteristics and loss (tan $\delta$), and therefore Q also.

Generally, it is preferred that the tuning characteristics meet the minimum required tuning range with the minimum tuning voltage. Preferably, x = 0.5 in the $Ba_xSr_{1-x}TiO_3$ composition for room temperature operation, regardless of doping with other elements and pre- or post-process annealing. It will be appreciated that other f-e materials beside BSTO may be used as well. A metal layer 18 formed on the f-e layer 16 defines a gap 20 that is preferentially 3.0 to 5.0 microns wide. Preferably, metal layer 18 is 0.5 to 6.0 microns thick. More preferably, metal layer 18 is 1.5 to 2.5 microns thick. It will be appreciated that the gap 20 can be wider or narrower than this range depending on requirements and processing equipment. For minimum added loss in the PCS band, the resulting capacitance will be approximately 0.6 pF to 1.5 pF at 0 volts DC while for the cellular CDMA band it will be about 1.0 pF to 3.0 pF. The width of the capacitor, W 17, will further determine the f-e capacitance, depending on the particular f-e film used and the desired gap 20. The width will typically be from .25 mm to 2.0 mm. The capacitance is typically 0.6 to 3.0 pF. The resulting capacitor should provide a Q of at least 160 at 2.0 GHz to meet the existing worst case CDMA PCS band BPF loss specification.

To minimize the added loss from the f-e film, selective deposition must be used, i.e., the f-e film is deposited only where needed for tuning and nowhere else as stated above. For example, in the gap capacitor 20 of Figure 1a, one could deposit the desired f-e film 16 in a narrow region $D_{f-e}$ around the gap 20, as shown in Fig. 1a. $D_{f-e}$ should be large enough to ensure that the gap 20 can be repeatedly patterned over the f-e film in manufacturing (allowing for mask alignment tolerance) and to cover the needed area under the gap 20 for tuning purposes. For the L-band PCS filters, $D_{f-e}$ = 0.2 to 0.5 mm is adequate with 0.2 mm preferred. As the operating frequency increases $D_{f-e}$ can decrease. As the operating frequency decreases, $D_{f-e}$ can increase.

F-E film properties and fabrication will play a significant role in overall capacitor loss. Many techniques exist to mitigate and minimize f-e film loss. One feature of f-e films is that f-e film loss and tunability usually have an inverse relationship. That is, they usually must be traded off against each other. The greater the f-e $\kappa$ tuning range, the greater the f-e loss in most cases.

Thus, even though f-e materials can achieve a $\kappa$ tuning range of about 3 to 1, less tuning may be acceptable for a given filter application. In that case, less tuning would be chosen, with the benefit of less loss. For example, in the U.S. PCS CDMA band, the tuning requirement in the transmit band is from 1850 MHz to 1910 MHz, or about 4%. Thus, the f-e material can have significantly less tunability than 3 to 1.

For example, an f-e gap capacitor with 0.6 pF at 0V DC bias, needs to tune 33%, (from 0.6 pF down to 0.4 pF) to tune over the PCS transmit band. The actual tuning range depends on the BPF topology and the band over which the BPF must be tuned. The required tuning voltage to provide the 33% tuning in this example depends on the f-e capacitor geometry, including f-e film thickness, and the f-e film characteristics.

The effect of $\kappa$ tunability on frequency tunability is determined by the filter topology. This effect must also be considered in choosing an f-e material. But without accurate characterization of the f-e loss to f-e $\kappa$ tunability trade-off, a designer cannot even begin to choose an optimum f-e material. Accurate characterization of this trade-off allows a designer to choose an optimum f-e material (providing the lowest loss while meeting the tuning requirements).

With respect to $L_{geom}$ for a gap capacitor, the major contributions to loss are the four corners formed by the gap. These losses can be reduced by rounding the corners. -

In comparison to gap and interdigital capacitors, an overlay capacitor has the lowest $L_{geom}$. An overlay capacitor is an example of a parallel plate geometry where the plate dimensions (length and width) are much greater than the plate separation. Given such a geometry, most of the electric field between the plates is uniform except for fringing along the edges. The fringing effect can be reduced significantly by the use of a guard band, as is well known in the art. Thus, the geometric loss from a parallel plate capacitor is quite low. In addition, parallel plate geometries can provide high capacitances along with high tuning from small control voltage swings.

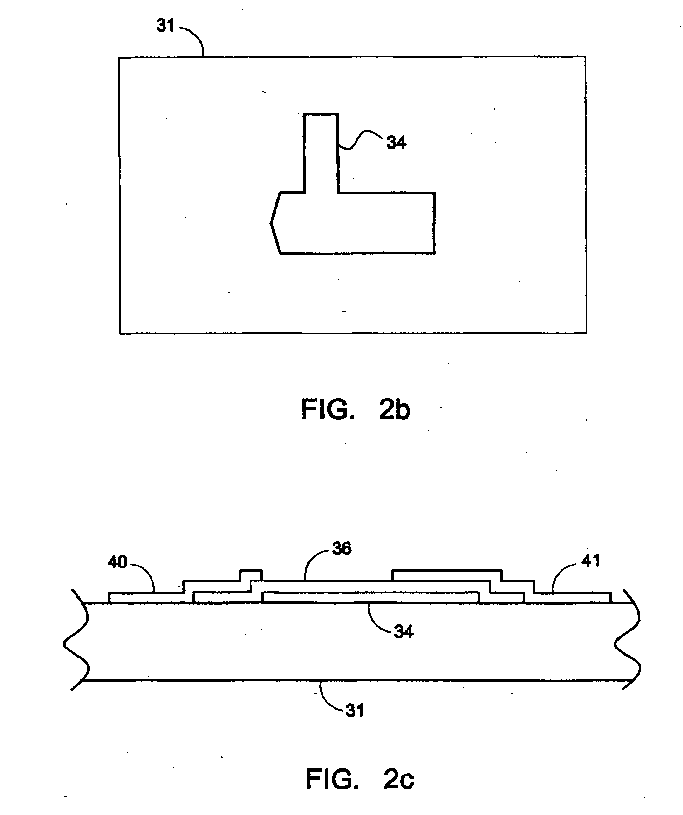

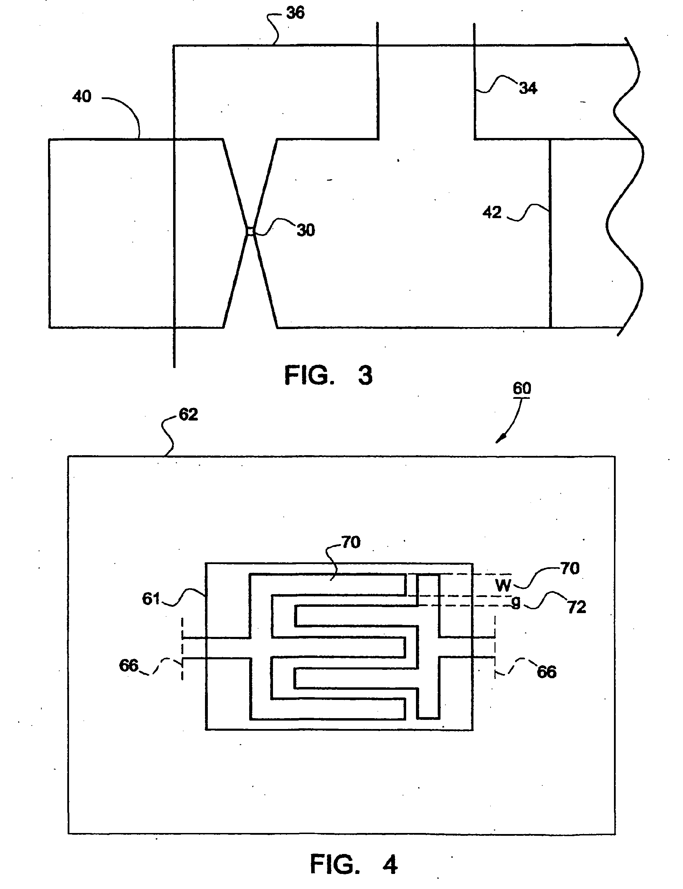

A preferred overlay capacitor 30 is illustrated in Figures 2a, 2b, 2c, and 3 that minimizes contributions to $L_{geom}$. The capacitor 30 is deposited directly on a 25 mil alumina substrate 31. A first metal layer 34 bonds to the substrate 31. The shape of metal layer 34 is also illustrated in Figure 2b. A ferro-electric layer 36 overlies the metal layer 34. To form the overlay capacitor 30, a metal pad 40 formed on the ferro-electric layer 36 overlaps a portion of the first metal layer 34. Figure 3 illustrates an enlarged view of the overlapping portions. Both the metal pad 40 and the metal layer 34 have a tapering region that forms an overlay capacitor 30 of the appropriate capacitance. An additional metal pad 41 overlaps the metal layer 34 to form a DC blocking capacitor 42. The metal pad 41 is tapered to form an appropriate capacitance for the DC blocking capacitor 42.

Due to the high dielectric constant ($\kappa$) of the most likely f-e films to be used, the overlay capacitor 30 may be quite small in area and still provide a capacitance ($C_{f-e}$) of 1.5pF. A bonding bias pad 44 is provided for attachment of a high value (500-1000k$\Omega$) chip resistor. Note that the f-e film is deposited not only under the overlay capacitor 30 but also the blocking capacitor 42. However, the effect on the capacitance ($C_{DC}$) of the DC blocking capacitor 42 is irrelevant if $C_{DC} \geq 180$ pF and $C_{f-e} \leq 1.5$ pF, even under maximum $V_{DC}$ bias (preferably 10V DC). This is because the DC blocking capacitor has a high enough capacitance that even when the capacitance is reduced by f-e tuning, it still has a minimal effect on $C_{f-e}$.

In such an embodiment, $0.7 \leq C_{f-e} \leq 1.5$ pF, f-e $\kappa$ is approximately 1000, the overlapped portion of the metal pad 40 forming the overlap capacitor 30 is approximately 7.0 $\mu$m X 7.0 $\mu$m, and the f-e film thickness is approximately 1.0 $\mu$m. The metal layer 34 may be Pt and have a thickness of $\leq 0.5$ $\mu$m. The metal pads 40 and 41 may be Ag and have a thickness of approximately 1.5-2.5 $\mu$m.

While the $L_{geom}$ of an overlay capacitor is lower than that of a gap capacitor, $L_{f-e}$ of an overlay capacitor may be higher, as all of the rf field is concentrated in the f-e film. In a gap capacitor the rf field is partially in air, partially in the f-e film and partially in the substrate. For the same reasons, an overlay capacitor has greater capacitance tunability for a given applied voltage than a gap capacitor.

For a given cross sectional area, an IDC can provide a higher capacitance than a gap capacitor. It is more lossy, however, with the main contributions to $L_{geom}$ including the gap spacing; loss increases as the gap spacing decreases. Similarly, loss increases as finger width decreases. The finger length also affects loss with loss increasing as finger length increases; especially in a microstrip (the most common) realization of an IDC as the odd mode loss dominates in such a structure. In addition, loss increases as the number of fingers increases due to loss introduced from the additional sharp corners; note that increasing the number of fingers is typically used to increase the capacitance of an IDC. Many investigators in the f-e area have used IDC's with narrow finger widths and gaps ($\leq 5.0~\mu m$ for each) to characterize f-e film. This is problematic, as such an IDC structure gives a high $L_{geom}$ and therefore a low Q by itself. Typically, $Q \leq 200$ at 2.0 GHz for about 1.0 pF, even without any $L_{f-e}$. This makes it quite difficult to measure $L_{f-e}$. The wide spread use of broad band measurement techniques, as described above, further obfuscates any $L_{f-e}$ measurement.

A preferred IDC capacitor 60 is illustrated in Figure 4 that minimizes the contributions to $L_{geom}$. It is formed on a 99 % alumina, MgO, sapphire or other suitable substrate 62 of thickness of approximately 0.2 to 1.5 mm. A f-e layer 64 is formed on the substrate 62. An input port 66 and output port 68 couple to the IDC capacitor 60. A metal layer 70 having a thickness of 1.5 to 3.0 microns and deposited on the f-e layer 64 forms a gap spacing 72 of approximately 5.0 microns and a finger width 70 of about 150 microns or greater if possible.

A general methodology for constructing a tunable bandpass filter may now be described. As a first step, a designer must tradeoff the 3 dB bandwidth of the tunable filter with filter order to achieve the required out-of-band rejection. As is well known, as the filter order is increased, its rolloff rate increases, making it easier to achieve a required rejection specification. The rolloff is modeled as beginning at either of the 3dB points defining the 3dB bandwidth (BW). Thus, as the BW is decreased, it also becomes easier to achieve a required rejection specification.

For minimum loss the lowest order filter is desired. Typically, this will be a 2nd order BPF. A low order BPF has a further advantage of being simpler to fabricate and tune, using fewer tunable resonators.

A Chebychev prototype BPF is preferred over a Butterworth as this gives the designer more flexibility to trade off passband ripple with out-of-band rejection. The designer should strive to meet the worst case rejection specification by bandwidth adjustment without the addition of extra transmission zeros as transmission zeros increase filter complexity, cost and loss at the corresponding passband edge. One can, however, exploit topologies that have naturally occurring high or low side transmission zeros in this case.

Narrowing BW too much, however, will increase the insertion loss, as discussed above. Thus, the narrowest BW should be chosen that meets the required rejection specification over all specified operating conditions. If the chosen BW provides an unacceptable insertion loss, the BW should be increased, perhaps also requiring an increase in filter order or increased passband ripple (if acceptable). An additional high or low side transmission zero may be added if desired.

A tunable BPF requires control circuitry. This is an added expense, not required of fixed-tuned BPF's. Thus, a desirable tunable filter design should provide a decreased insertion loss, smaller size, or other benefit over that of a fixed-tuned BPF to offset this expense. To achieve decreased insertion loss and smaller size, it is preferable to use no more than a one or two stage tunable filter. However, it will be appreciated that the principles of the invention may be advantageously used to design tunable f-e filters of arbitrary order.

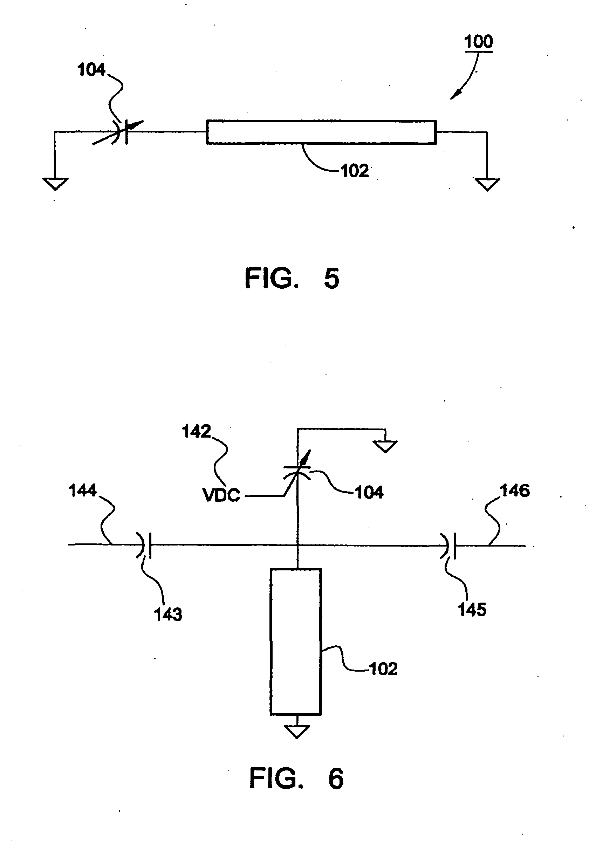

Given a choice for filter order and BW that satisfies the rejection requirements, the highest possible $Q_u$ for a resonator should be used to meet or exceed the required I.L., given size and height constraints. To define $Q_u$, a topology should be chosen for the basic stage 100 illustrated in Figure 5. Each stage 100 is formed by a resonator 102 coupled to a f-e capacitor 104. The f-e capacitor 104 may assume one of the forms described herein. The resonator 102 is shown as a grounded quarter wavelength resonator but an open circuit one-half wavelength resonator may also be used. Moreover, the resonator may be of other suitable electrical length.

The basic stage 100 may be considered a tunable EM resonator. The f-e capacitor 104 may be coupled either in series or in shunt with the resonator 102 as determined by the nature of their connection. As shown in Figure 6, the f-e capacitor 104 is coupled in shunt with the resonator 102 such that $Q_{f-e}$ of the f-e capacitor 104 affects the Q of the fix-tuned EM resonator 102. Volumetric resonators (e.g., coaxial, stripline, and monoblock) are preferred, as they provide the highest $Q_u$ and smallest area and height at a minimal price compared to planar, i.e., microstrip, alternatives.

Whether a tunable capacitor is placed in series or shunt with a volumetric resonator is often determined by the case of the connection; sometimes only one placement is even possible. Another key feature in determining whether a tunable capacitor is placed in series or shunt is that of minimum added loss and to a lesser extent, tuning range. A shunt connection will typically produce a more physically compact tunable filter than a series connection. It is usually easier to achieve as well. A series connection can provide better tuning in the case where electromagnetically coupled resonators (like monoblock, coaxial or stripline) are coupled along their entire extent (rather than coupled through a small aperture).

A series connection is a more natural choice in these cases from a fabrication perspective.

As discussed above, the attachment losses may be significant if the f-e capacitor 104 is not integrated with the resonator 102 or other RF circuitry. Once a topology for the f-e capacitor 104 is chosen, its $Q_c$ may be derived as discussed above. $Q_T$ for the overall basic stage 100 is then given by $1/Q_T = 1/Q_c + 1/Q_u$, where $Q_u$ is the unloaded Q of the resonator 102;
and Qc is the Q of the f-e capacitor.

Given the $Q_T$ for the basic stage 100, the designer may use equation (1) to determine if the required I.L. will be achieved or exceeded. Should the I.L. be too high, the designer may obtain a lower I.L. by increasing either or both of $Q_c$ or $Q_u$. If either $Q_c$ or $Q_u$ cannot be increased further, they will ultimately limit $Q_T$. Further reduction of I.L.$_o$ can then be obtained only by switching to a lower loss topology. For example, $Q_u$ may be increased if a volumetric instead of a microstrip resonator is used for a given footprint (area).

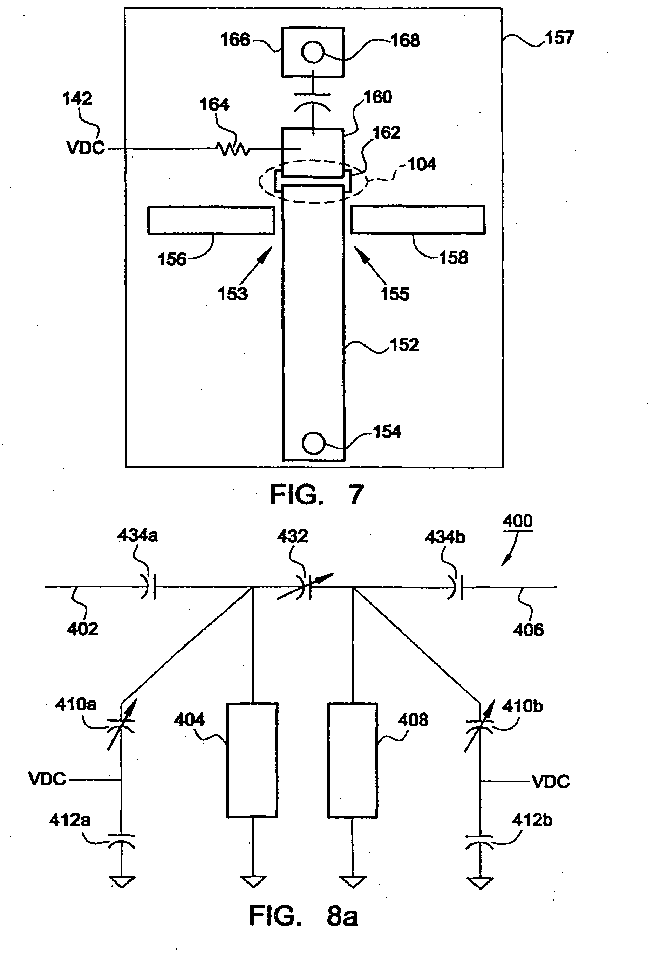

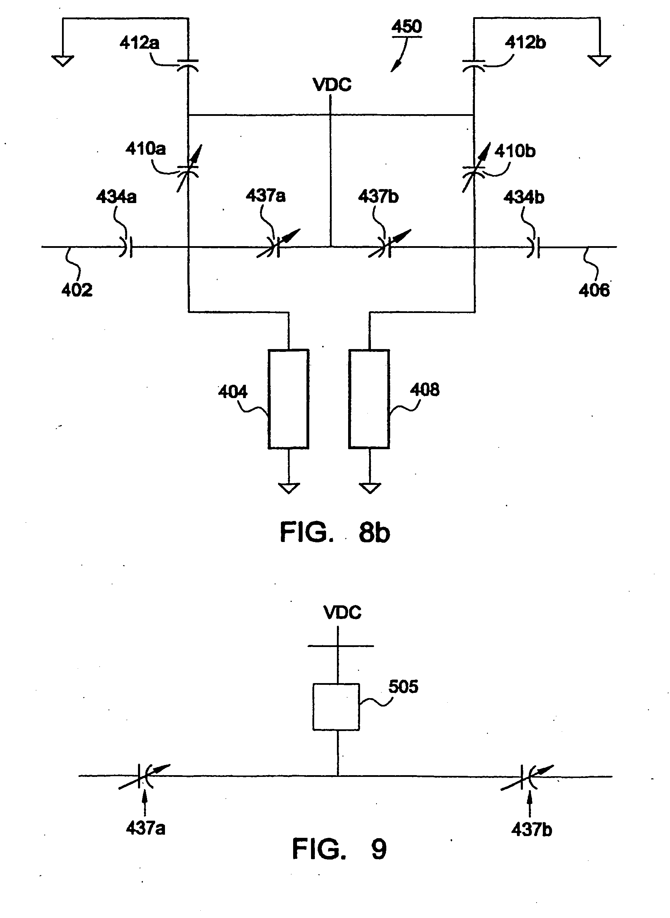

For high volume applications, such as CDMA wireless handsets, transverse electromagnetic (TEM) wave volumetric resonators are preferred. Such volumetric resonators can be either ceramic loaded coaxial resonators, slabline (monoblock) or stripline, to name the three most common realizations. The standard narrow band (typically defined as a BW $\leq$ 10% of $f_o$) topology can be realized using top capacitively coupled (TCC) BPF's fabricated with either coaxial or stripline resonators. The TCC topology as shown in Fig. 8, lends itself to shunt f-e tuning, as this provides the most compact realization (having a smaller footprint than a TCC topology with series f-e tuning). Also, the shunt quarter wave resonators behave as parallel LC tuned circuits near resonance.

Stepped impedance realizations of monoblock BPF's can be used as well. Monoblock resonators are typically EM coupled along their entire length, a direct consequence of their design. They lend themselves to series f-e tuning. Their electrical lengths can be tuned by the selective deposition and patterning of f-e tuning capacitors. Non-TEM resonators can be used as well, including, but not limited to, dielectric loaded waveguide resonators or dielectric pucks (with or without a shielded enclosure).

However, height restrictions may limit the achievable $Q_u$ from volumetric resonators. An alternative to a volumetric coaxial resonator in such height-constrained systems is to use a stripline resonator. Here, one can make the center conductor wider (up to a point) thus improving $Q_u$ while keeping the total height fixed. This embodiment has further merit in that the incorporation of a planar f-e capacitor such as a gap capacitor or IDC can be realized efficiently by making the top cover of the stripline resonator end before the location of the f-e capacitor. In this manner, the planar f-e capacitor would be formed on the portion of the substrate forming the bottom cover of the stripline resonator that extends beyond the top cover.

Regardless of the particular resonator being implemented, if height restrictions prevent any further increase in the $Q_u$ of the resonator, $Q_c$ would have to be increased instead by, for example, replacing an IDC f-e capacitor with a gap or an overlay f-e capacitor.

For many applications, a single stage bandpass filter 140 will be satisfactory as illustrated in Figure 6. As discussed with respect to Figure 5, the bandpass filter 140 will include the f-e capacitor 104 and the resonator 102. A variable DC voltage 142 applied to the f-e capacitor 104 tunes the filter 140. The RF signal to be filtered is applied at input port 144 and is output at output port 146. Note that the input port 144 and output port 146 are interchangeable. A capacitor 143 is defined both between the input port 144 and the resonator 102. Another capacitor 145 is defined between the output port 146 and the resonator 102. The f-e capacitor 104, regardless of whether it is a gap, overlay, or IDC capacitor, is constructed to minimize losses in the manner described above. Similarly, the resonator 102, which may be either a shorted ¼ wavelength resonator or a ½ wavelength open circuit resonator, is selected to maximize $Q_u$.

A higher $Q_u$ will be provided by a volumetric resonator such as a coaxial resonator, a dielectric loaded waveguide, a monoblock, or a stripline resonator in a smaller footprint and at a lower cost. Alternatively, a larger area planar resonator such as a microstrip resonator may be used if specifications and price constraints permit. Most microstrip resonator circuits would be fabricated by thin film process on a hard substrate. They can achieve less metal thickness and are of larger size since part of the EM field is the air region above the microstrip.

Turning now to Figure 7, a planar realization 150 of the bandpass filter 140 is illustrated. Resonator 102 is formed by a microstrip line 152 grounded through via 154. Note that microstrip line 152 could also be terminated in a suitable lossless ground plane (not illustrated), obviating the need for via 154. Capacitors 153 and 155 are formed by gaps between the input and output microstrip lines 156 and 158 and the resonator microstrip line 152. It is desirable to make the capacitance of capacitors 155 and 157 as large as practical (approximately 0.2 pF) to maximize input and output coupling while still maintaining a planar structure. The microstrip lines are formed on substrate 157 of 99.5 % pure alumina, MgO, or sapphire that is preferably of thickness approximately 1.0 mm for providing a maximum microstrip resonator Q. The f-e capacitor 104 is formed as a gap capacitor by pad 160 and mircrostrip line 152, with f-e layer 162 underneath pad 160 and microstrip line 152.

A variable DC voltage source biases pad 160 through resistor 164. A DC blocking capacitor is positioned between pads 160 and 166, where pad 166 includes a via 168 to ground. Note that pad 166 could also be terminated in a suitable lossless ground plane (not illustrated), obviating the need for via 168.

The DC blocking capacitor is needed if the resonator is shunted as shown in Fig. 7. The capacitance of the DC blocking capacitor is ideally at least $10OC_{f-e}$ to minimize its loading effects on $C_{f-e}$. Its Q is ideally $\geq 40$ in the band of interest. It will be appreciated that the choice of a gap capacitor and a microstrip resonator is arbitrary - any of the forms discussed herein could be employed consistent with the teachings of the present invention.

The bandpass filter of Fig. 7 may be ideally used as a test circuit to characterize an f-e film as described herein. As such, the bandpass filter of Fig. 7 provides the following advantages:

1) The f-e capacitor can be fabricated as it is to be used, particularly if that realization is a gap capacitor or IDC. Selective f-e deposition is used.

2) While an f-e gap capacitor is shown, an IDC could be used as well. A gap capacitor has a simpler geometry. It is easier to fabricate and has lower geometric loss compared to an IDC. It is also easier to fabricate than an overlay capacitor.

3) Since the circuit is fabricated with thin film processing techniques the geometry can be precisely controlled and measured.

4) Metal thickness can be accurately measured by profilometry. Metal type can be selected as desired (Au, Ag or Cu).

5) A high Q microstrip circuit completes the fixed resonator part of the circuit.

6) The f-e capacitor is directly fabricated in the resonator. There is no added loss due to soldering, bonding, etc. The transition from resonator to f-e capacitor is uniform, or it can be tapered, if desired.

7) No via holes are needed if large area ground planes and a Wiltron test fixture (with jaws to hold and ground the circuit top and bottom) is used. Drilling vias in hard substrates is a significant cost adder and reduces the number of such test circuits that can be fabricated.

8) This circuit can be accurately modeled in EM software.

9) This circuit can be fabricated without f-e film to determine a base loss (at a higher $f_o$, of course) of the circuit for correlation to simulations.

10) The use of a low loss substrate minimizes its effect on the overall circuit.

11) Measured results of $f_o$ and $I.L_o$. can be used to extract f-e film dielectric constant and tan $\delta$.

12) The circuit in Fig. 7 can be fabricated with an aperture in the base substrate where the f-e cap is shown. Now, independent f-e caps can be placed over the aperture, held in place with pressure, allowing the f-e caps to be tested as stand-alone components.

Referring now to Fig. 8a, a two stage TCC tunable BPF 400 is illustrated. As discussed with respect to Figure 5, each stage of bandpass filter 400 comprises a resonator 404 and 408 and f-e capacitor 410a and 410b. The resonators 404 and 408 are shown as $\frac{1}{4}$ wavelength short-circuited resonators but may also be $\frac{1}{2}$ wavelength open circuit resonators.

A variable DC voltage applied to the f-e capacitors 410a and 410b tunes the bandpass filter 400. The ferro-electric capacitors 410a and 410b couple to ground through DC blocking capacitors 412a and 412b, since the resonators are shorted in this example.

An RF signal is received at input port 402 and output at output port 406. Note that input port 402 and output port 406 are interchangeable. In addition to input capacitor 434a and output capacitor 434b, which are functionally similar to capacitors 143 and 145 discussed with respect to Figure 6, an additional capacitor 432 is provided as an impedance and admittance inverter between the resonators 404 and 408 to create the desired BPF response. It will be appreciated that capacitor 432 can also be a discrete element or implemented through aperture coupling between resonators 404 and 408.

The tunable two-stage filters 400 and 450 illustrated in Figs. 8a and 8b have a basic topology which creates a high or low side zero that can be used to provide better rejection for a given passband I.L. In the case of inter-resonator coupling along their entire length, the passband I.L. and out-of-band rejection will change as the ferro-electric capacitors tune the bandpass filter across the passband. To minimize any resulting distortion, particularly in the rejection band, capacitor 432 may be a f-e capacitor. Tuning capacitors 413 and 419 makes the zero track in frequency with the tunable passband.

To facilitate the biasing and tuning of f-e capacitor coupling between the resonators 404 and 408, capacitor 432 may be replaced by f-e capacitors 437a and 437b as shown in Fig. 8b. Capacitors 437a and 437b ideally have a capacitance twice that of capacitor 432. In this embodiment, the ferro-electric capacitors 410a, 410b, 437a and 437b may all be tuned using a single DC tuning voltage VDC.

The single DC tuning voltage for the f-e capacitors may be arranged as shown in Fig. 9. In Fig. 9, $V_{DC}$ is coupled to a divider network 505. The divider network 505 is coupled to both f-e capacitors 437a and 437b. The divider network 505 is configured to provide the appropriate tuning range to the f-e capacitors 437a and 437b so as to cause the zero to track with the passband, as described above.

The divider network 505 may be constructed as shown in Fig. 10. In Fig. 10, $V_{DC}$ is coupled to $R_1$. $R_1$ is coupled to $R_2$ and to both capacitors 437a and 437b. $R_2$ is also coupled to ground. $R_1$ and $R_2$ are chosen to cause the zero to track with the passband, as described above.

Alternatively, a separate voltage can be used to tune both capacitors 437a and 437b.

Turning now to Figure 11a a tunable two-stage filter 300 using coaxial, monoblock resonators 302a and 302b is illustrated. Note that other resonator types could also be used. The resonators 302a and 302b may be open or short circuited. The resonators 302a and 302b attach to a first surface of a substrate 301. Pads 304a and 304b formed on the first surface of the substrate 301 couple to the resonators 302a and 302b through leads 305a and 305b. Pads 306a and 306b formed on the first surface of substrate 301 couple to pads 304a and 304b creating the desired gap for the ferro-electric capacitors 310a and 310b. Ferro-electric layers 312a and 312b underlying the pads 304a and 304b and 306a and 306b complete ferro-electric gap capacitors 310a and 310b. Note that the drawings are not to scale. Typically, the gap spacing is increased for clarity.

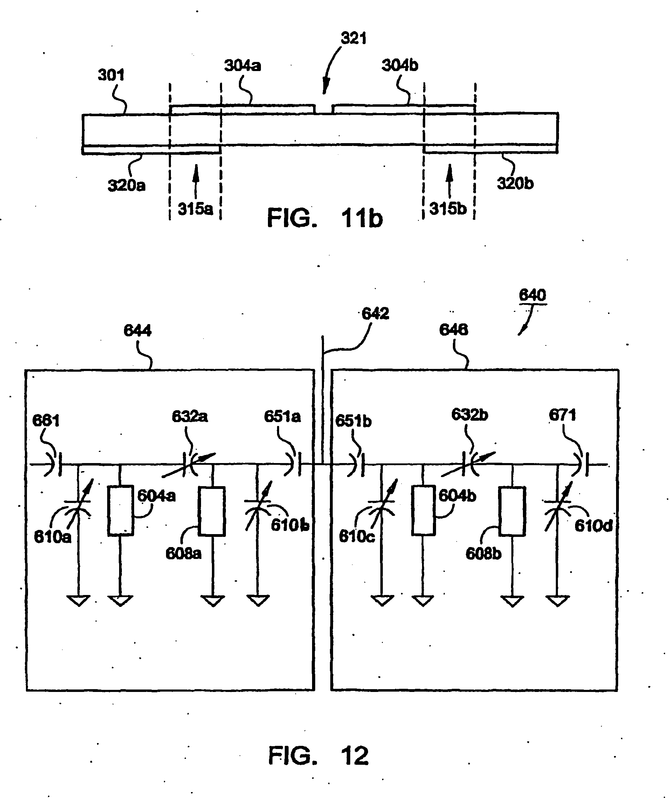

There are transmission lines 320a and 320b on a second surface of substrate 301. These transmission lines are used as input and output ports 320a and 320b for signals RF in and RF out. The input and output capacitors 315a and 315b are formed between the transmission lines 320a and 320b and the pads 304a and 304b with substrate 301 in between, as shown in Fig. 11b. Fig. 11b is a cross-sectional view of a portion of filter 300 shown in Fig. 11a. The cross-section is taken along line B.

In addition, capacitor 321 is formed as a gap capacitor by the separation of pads 304a and 304b. Note that the coupling provided by capacitor 321 may alternatively be provided though aperture coupling between coaxial resonators 302a and 302b, eliminating the need for capacitor 321. It will be appreciated that although the coaxial resonators 302a and 302b are shown as separate structures, they may share a common wall to save space and permit any aperture coupling. Additionally, there may be no space and no wall between them. I.e., they may be mutually coupled monoblock resonators. In embodiments in which the coupling provided by capacitor 321 is implemented through aperture coupling, the pads 304a and 304b would be separated by a sufficient distance to minimize any gap capacitance between them. A bias voltage VDC couples through resistors 340a and 340b to tune the ferro-electric capacitors 310a and 310b. Each of the ferro-electric gap capacitors 310a and 310b couple to ground through DC blocking capacitors 341a and 341b.

The filters 400 and 450 may be adapted to serve as the transmitting and receiving section of a duplexer 640 as shown in Figure 12. Note that duplexers are a special case of multiplexers. Duplexers are used in conjunction with two bands, while multiplexers are used in conjunction with two or more bands. Alternatively, multiplexers may be defined as for use with more than two bands. Either way, it is to be understood that the present invention can be used in multiplexers generally, even though the discussion is in terms of duplexers, for simplicity.

The duplexer 640 couples to an antenna or diplexer through a common port 642. A transmitting section 644 comprises a two-stage tunable filter constructed as discussed with respect to Figures 9, 10 and 11. Thus, transmitting stage 644 has resonators 604a and 608a coupled to their ferro-electric capacitors 610a and 610b, respectively. Resonators 604a, 604b, 608a and 608b may be realized as coaxial, stripline or monoblock resonators, to give three examples. The Tx and Rx sections are typically fabricated with the same topology, for example, monoblock. However, one could use different topologies for Tx and Rx sections if desired. For example, the Tx section could be stripline while the Rx section could be monoblock, depending on requirements, or choice.

If realized as monoblock resonators, they may be EM coupled along their entire length. This EM coupling, along with the coupling provided by capacitor 632a, can be used to create a high side rejection zero located in the Rx band. Ideally, the zero is located in that portion of the Rx band that contains the Rx channel that is paired with the Tx channel in PCS CDMA. This topology provides minimum Tx band I.L.$_0$ along with mazimum Rx band rejection.

The DC blocking capacitors and the DC tuning voltage source are not illustrated. Ferro-electric capacitor 632a is illustrated as implemented in Figure 8a. However, it will be appreciated that it is preferably implemented as two series-coupled f-e capacitors each of capacitance 2C2 as shown in Figure 8b. The DC return path for capacitors 610a and 610b is through the shorted resonators 604a and 608a.

The receiving section 646 is constructed analogously. The same comments regarding monoblock coupling and Tx band rejection apply here, analogous to thos.e made regarding Rx band rejection for the Tx filter. However, the electrical lengths of the resonators 604b and 608b in receiving section 646 are chosen differently than those in the transmitting section. In this manner, the passbands over which the sections tune are separated while the capacitance values of the f-e tuning capacitors 610c and 610d remain the same as that of capacitors 610a and 610b.

For example, in the full U.S CDMA PCS band, the transmitting (TX) section 644 would have to tune to transmit over a passband from 1850 to 1910 MHz. Similarly, the receiving (RX) section 446 would have to tune to receive over a passband from 1930 to 1990 MHz. It should be noted that while the full US PCS band is described here, the same concepts apply to other wireless bands, including, for example, the cellular band (800 MHz to 1000 MHz), other PCS bands, 3-G CDMA bands, and any partial bands.

The tuning voltage range for the Tx and Rx bands will not be the same in this case, since even though the required tuning range is 60 MHz (in the example of the full U.S. PCS band), the fractional bandwidths for Tx and Rx are slightly different. This is because the Tx band starts at 1850 MHz, while the Rx band begins at 1930 MHz. Thus, separate tuning voltages will be required in the case where equal value f-e capacitors are used.

In another embodiment, resonators 604a and 608a for the Tx band have the same electrical length for as resonators 604b and 608b for the Rx band. In this case, the capacitance values of the f-e capacitors used to tune the Tx and Rx bands would be different, providing the necessary frequency separation.

The F-E capacitors 610a-d can be used to tune the individual resonators as well. In conventional fixed bandwidth designs each filter or duplexer requires 100% vendor screening and tuning to meet electrical specifications. The use of electrically tunable f-e capacitors can be exploited for this purpose, to compensate for dielectric constant variations, fabrication tolerances and temperature variations. This tuning comes at the price of added tuning capacitance range and ideally is performed by independent tuning (control) voltages for each resonator. This approach increases the demand placed on the control circuitry that generates the DC control voltages.

In another embodiment, a PCS-configured duplexer may use gap coupling to form the capacitors 651a, 651b, 661 and 671. Capacitors 651a, 651b, 661 and 671 are typically in the range 0.25 to 0.3 PF for the US PCS CDMA band. They transform the impedance of the BPF or duplexer to the correct input and output impedances, which is typically 50 ohms.

Additional impedance matching circuitry may be needed at the common port 642 rather than just using capacitors 651a and 651b, as shown. The system requirements for a specific application will determine what voltage standing wave ratio (VSWR) must be seen looking into port 642 when the Tx and Rx parts are terminated in their correctly specified impedances (typically 50 $\Omega$).

A filter or duplexer (or multiplexer) is a frequency selective impedance transforming network. As such, it can be designed to transform impedance levels between its input and output ports to and from values other than the standard 50 ohms. With this in mind, capacitors 661 and 671 may take on a wider range of values, as required. Capacitors must be chosen to give the correct capacitance in any case.

In one embodiment, where the dielectric constant (DK) of the ceramic in the resonators 604a, 604b, 608a and 608b is 38.6. The resonators 604a and 608b in the transmitting section 644 have an electrical length of 232 mils whereas the resonators 604b and 608b in the receiving section 646 have an electrical length of 221 mils. The f-e capacitors 610a-d have a capacitance of 0.66pF and a Q of 180.

In another embodiment, monoblock filters fabricated with a ceramic DK = 38.6 are used, with a height of 4.0 mm, a Zoe = 18.95 $\Omega$, Zoo = 13.80 $\Omega$, a center conductor diameter of 36.24 mils, and center conductor spacing edge to edge of 64.68 mils.

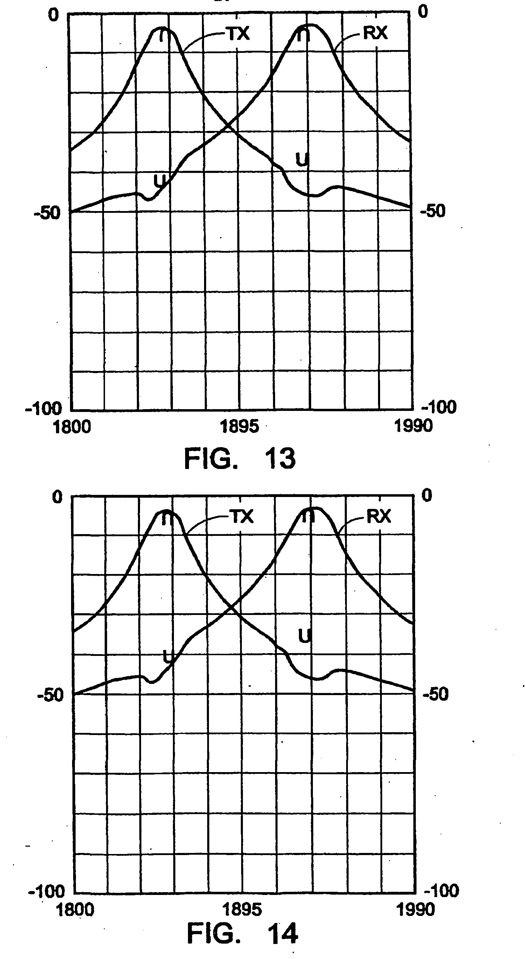

The resulting frequency responses for such PCS-configured sections 644 and 646 are as shown in Figures 13. Figure 14 illustrates the resulting frequency responses should the Q of the f-e capacitors 610a-d be increased to 450. The responses in Figs. 13 and 14 are based on 4.0 mm coaxial resonators with no EM coupling between them.

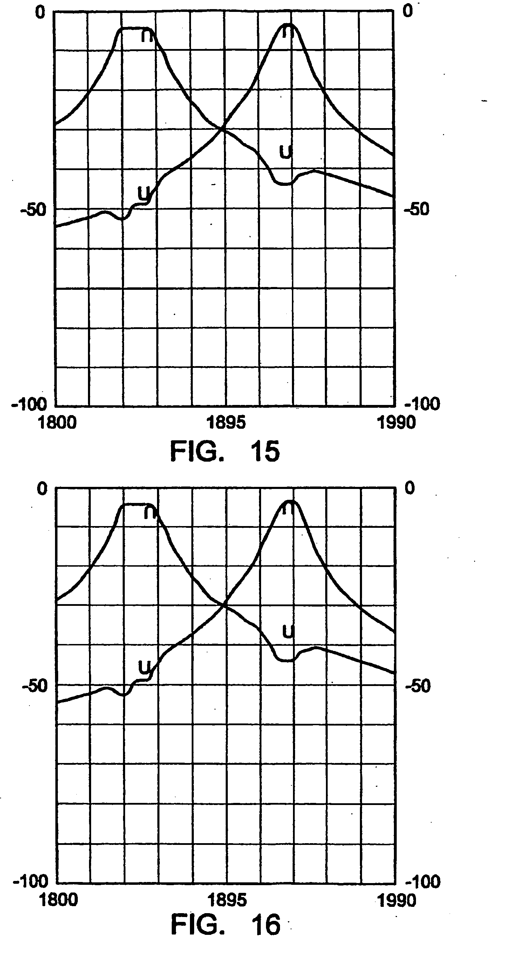

In another embodiment, capacitors 651a, 651b, 661 and 671 may be implemented as discrete overlay capacitors having a quality factor of 250 or greater. In this embodiment, the resonators 604a and 608b in the transmitting section 644 may have an electrical length of 233.179 mils whereas the resonators 604b and 608b in the receiving section 646 may have an electrical length of 222.32 mils. Should the ferro-electric capacitors 610a-d have a capacitance of 0.66 pf and a quality factor of 180, the frequency response for the resulting PCS-configured duplexer is as illustrated in Figure 15. Similarly, if the quality factor of the ferro-electric capacitors 610a-d is increased to 450, the frequency response is as illustrated in Figure 16. Figures 13-16 are examples of frequency responses of example duplexers.

In any of these embodiments, the Q of the f-e caps can be lower, as long as an increased passband I.L. can be tolerated. If the specification for worst case passband I.L. is -3.5 dB for Tx band, one can use a $C_{f-e}$ = 0.66 pF with an associated Q of about 80 at 2.0 GHz and still meet the specification. The f-e capacitors' Q may need to be higher to account for fabrication losses such as $L_{attach}$.

The preferred solution is to obtain the highest f-e capacitor Q possible while meeting the tuning requirements. This will provide the minimum I.L.$_0$ in both Tx and Rx bands. A smaller $C_{f-e}$ results in less loading of the BPF or duplexer at 1900 MHz. The lower limit on $C_{f-e}$ is imposed by tuning range. In the embodiment shown in Figs. 12-16, a minimum delta ($\Delta$) $C_{f-e}$ (of capacitors 410a and 410b of Fig. 8a) = 0.25 pF along with a $\Delta C_{f-e}$ (of capacitor 432 of Fig. 8a) = 0.033 pF is needed in an EM coupled monoblock design, and $\Delta C_{f-e}$ (of capacitors 410a and 410b of Fig. 8a)= 0.34 pF is needed in a non-EM coupled design. A lower passband I.L. is typically preferred particularly in power sensitive applications like handsets, since a lower passband I.L. places less demands on other components, such as power amplifiers. This, in turn, has a positive impact on battery life or talk time.

Using the monoblock design as an example, if a $C_{f-e}$ tuning range of 2:1 is achievable for a given f-e film, DC tuning voltage and f-e capacitor topology, then $C_{f-e}$ (0V DC) = 0.5 pF would be the minimum $C_{f-e}$ that would achieve the $\Delta C_{f-e}$ = 0.25 pF required. If one wished to start with $C_{f-e}$ (0V DC) = 0.375 pF, one would need a tuning range of 3:1 to achieve the $\Delta C_{f-e}$ = 0.25 pF required.

Although the invention has been described with reference to particular embodiments, the description is only an example of the invention's application and should not be taken as a limitation. Consequently, various adaptations and combinations of features of the embodiments disclosed are within the scope of the invention as encompassed by the following claims.

**Claims**

1. A tunable multiplexer (640) coupled to an antenna through a first port (642), comprising a first tunable filter (300, 644) having a first filter node coupled to the first port (642) and a second filter node coupled to a second input/output (I/O) port,

   **characterized by**

   a first signal filter having a first resonant frequency, comprising:

   a first ferro-electric "FE" material (312b) formed on a first surface of a substrate (301);
   a first conductive pad (304b) formed on the first surface of the substrate (301) any overlapping the first FE material (312b);
   a first resonator (302b, 608a) connected between the first filter node and a ground, wherein the first resonator (302b, 608a) is attached to the first surface of the substrate (301), and connected by a first lead (305b) to the first conductive pad (304b);
   a first capacitor pad (306b) formed on the first surface of the substrate (301) and overlapping the first FE material (312b) such that the first capacitor pad (306b) is separated from the first conductive pad (304b) by a first gap area to form a first ferro-electric "FE" tunable gap capacitor (610b), the first capacitor pad (306b) connected to the ground through a first DC blocking capacitor (341b);
   a first control voltage coupled to the first capacitor pad (306b), wherein the first FE material (312b) is responsive to the first control voltage to adjust a first capacitance of the first FE tunable capacitor (610b) and the first resonant frequency;

   a second signal filter having a second resonant frequency, comprising:

   a second ferro-electric "FE" material (312a) formed on the first surface of a substrate (301);
   a second conductive pad (304a) formed on the first surface of the substrate (301) and overlapping the second FE material (312a) ;
   a second resonator (302a, 604a) connected between the second filter node and the ground, wherein the second resonator (302a, 604a) is attached to the first surface of the substrate (301), and connected by a second lead (305a) to the second conductive pad (304a);
   a second capacitor pad (306a) formed on the first surface of the substrate (301) and overlapping the second FE material (312a) such that the second capacitor pad (306a) is separated from the second conductive pad (304a) by a second gap area to form a second ferro-electric "FE" tunable gap capacitor (610a), the second capacitor pad (306a) connected to the ground through a second DC blocking capacitor (341a);
   a second control voltage coupled to the second capacitor pad (306a), wherein the second FE material (312a) is responsive to the second control voltage to adjust a second capacitance of the second FE tunable capacitor (610a) and the second resonant frequency; and

   a third capacitor (321, 632a) connected between the first filter node and the second filter node.

2. The tunable multiplexer (640) of claim 1, wherein the third capacitor (321, 632a) is a third FE tunable capacitor comprising a third ferro-electric "FE" material formed on the first substrate (301), wherein the first conductive pad (304b) and the second conductive pad (304a) partially overlap the third FE material, and are separated by a third gap area, the third FE material responsive to a third control signal to adjust a third capacitance of the third FE tunable capacitor.

3. The tunable multiplexer (640) of claim 1, wherein a quality factor of the first FE tunable capacitor (610b) and the second FE tunable capacitor (610a) is greater than one of about 80, about 180, and about 350.

4. The tunable multiplexer (640) of claim 1, wherein a quality factor of the first FE tunable capacitor (610b) and the second FE tunable capacitor (610a), when operated in a temperature range between about -50 degrees Celsius and 100 degrees Celsius, is greater than about 80 in one of a first frequency range between 0.25 GHz and 7.0 GHz, a second frequency range between about 0.8 GHz and 7.0 GHz, a third frequency range between about 0.25 GHz and 2.5 GHz, and a fourth frequency range between about 0.8 GHz and 2.5 GHz.

5. The tunable multiplexer (640) of claim 1, wherein a quality factor of the first FE tunable capacitor (610b) and the second FE tunable capacitor (610a), when operated in a temperature range between about -50 degrees Celsius and 100 degrees Celsius, is greater than about 180 in one of a first frequency range between about 0.25 GHz and 7.0 GHz, and a second frequency range between about 0.8 GHz and 2.5 GHz.

6. The tunable multiplexer (640) of claim 1, wherein a quality factor of the first FE tunable capacitor (610b) and the second FE tunable capacitor (610a), when operated in a temperature range between about -50 degrees Celsius and 100 degrees Celsius, is greater than about 80 for one of a first capacitance in a range between about 0.3 pF and 3.0 pF, and a second capacitance in a range between about 0.5 pF and 1.0 pF.

7. The tunable multiplexer (640) of claim 1, wherein a quality factor of the first FE tunable capacitor (610b) and the second FE tunable capacitor (610a), when operated in a temperature range between about -50 degrees Celsius and 100 degrees Celsius, is greater than about 180 for one of a first capacitance in a range between about 0.3 pF and 3.0 pF, and a second capacitance in a range between about 0.5 pF and 1.0 pF.

8. The tunable multiplexer (640) of claim 1, wherein:

   the first resonant frequency is between a range of about 1850 MHz to about 1910 MHz; and
   the second resonant frequency is between a range of about 1930 MHz to about 1990 MHz.

9. The tunable multiplexer (640) of claim 1, wherein:

   the first resonant frequency is between a range of about 1750 MHz to about 1780 MHz; and
   the second resonant frequency is between a range of about 1840 MHz and about 1870 MHz.

10. The tunable multiplexer (640) of claim 1, further comprising:

    a second tunable filter (646) having a third filter node coupled to the first port (642) and a fourth filter node coupled to a third input/output (I/O) port, comprising:

       a third signal filter having a third resonant frequency, comprising:

          a fourth ferro-elecric "FE" material formed on the first surface of the substrate (301);
          a third conductive pad formed on the first surface of the substrate (301) and overlapping the fourth FE material;
          a third resonator (604b) connected between the third filter node and the ground, wherein the third resonator (604b) is attached to the first surface of the substrate (301), and connected by a third lead to the third conductive pad;
          a third capacitor pad formed on the first surface of the substrate (301) and overlapping the fourth FE material such that the third capacitor pad is separated from the third conductive pad by a fourth gap area to form a fourth ferro-electric "FE" tunable capacitor (610c) connected between the third filter node and a third DC blocking capacitor coupled to the ground;
          a fourth, control voltage coupled to the third capacitor pad, wherein the fourth FE material is responsive to the fourth control voltage to adjust a fourth capacitance of the fourth FE tunable capacitor (610c) and the third resonant frequency;

       a fourth signal filter having a fourth resonant frequency, comprising:

a fifth ferro-elecric "FE" material formed on the first surface of the substrate (301);

a fourth conductive pad formed on the first surface of the substrate (301) and overlapping the fifth FE material;

a fourth resonator (608b) connected between the fourth filter node and the ground, wherein the fourth resonator (608b) is attached to the first surface of the substrate (301), and connected by fourth lead to the fourth conductive pad;

a fourth capacitor pad formed on the first surface of the substrate (301) and overlapping the fifth FE material such that the fourth capacitor pad is separated from the fourth conductive pad by a fifth gap area to form a fifth ferro-electric "FE" tunable capacitor (610d) connected between the fourth filter node and a fourth DC blocking capacitor coupled to the ground;

a fifth control voltage coupled to the fourth capacitor pad, wherein the fifth FE material is responsive to the fifth control voltage to adjust a fifth capacitance of the fifth FE tunable capacitor (610d) and the fourth resonant frequency; and

a sixth tunable capacitor (632b) connected between the third filter node and the fourth filter node.

11. The tunable multiplexer (640) of claim 10, wherein the first tunable filter (644) is a transmitter filter and the second tunable filter (646) is a receiver filter.

12. The tunable multiplexer (640) of claim 1, wherein the first resonator (608a) is constructed as a first volumetric resonator and the second resonator (604a) is constructed as a second volumetric resonator.

13. The tunable multiplexer (640) of claim 10, wherein each resonator of the first resonator (608a), the second resonator (604a), the third resonator (604b) and the fourth resonator (608b) comprises one of a stripline resonator, a monoblock resonator and a coaxial dielectric loaded resonator.

14. The tunable multiplexer (640) of claim 10, wherein a quality factor of each capacitor (610a, 610b, 610c, 610d) is greater than one of about 80, about 180 and about 350.

15. The tunable multiplexer (640) of claim 10, wherein the third resonant frequency is between a range of about 1850 MHz to about 1910 MHz; and the fourth resonant frequency is between a range of about 1930 MHz to about 1990 MHz.

16. The tunable multiplexer (640) of claim 10, wherein:

the first tunable filter (644) transmits frequencies between a range of about 1850 MHz to about 1910 MHz; and the second tunable filter (646) receives frequencies between a range of about 1930 MHz to about 1990 MHz.

17. The tunable multiplexer (640) of claim 10, wherein the sixth tunable capacitor (632b) is a sixth FE tunable capacitor comprising a sixth ferro-electric (FE) material positioned between conductive pads of the sixth FE tunable capacitor, the sixth FE material responsive to a sixth control signal to adjust a sixth capacitance of the sixth FE tunable capacitor.

18. A wireless communication device comprising:

the tunable multiplexer (640) of claim 11;
a battery;
a transceiver;
a user interface; and
a housing encasing the battery and the transceiver and adapted to present the user interface external to the housing.

**Patentansprüche**

1. Abstimmbarer Multiplexer (640), der durch einen ersten Anschluss (642) mit einer Antenne gekoppelt ist, aufweisend:

ein erstes abstimmbares Filter (300, 644) mit einem ersten Filterknoten, der mit dem ersten Anschluss (642) gekoppelt ist, und mit einem zweiten Filterknoten, der mit einem zweiten Eingangs-/ Ausgangs-(I/O)-Anschluss gekoppelt ist, **gekennzeichnet durch**:

ein erstes Signalfilter mit einer ersten Resonanz-Frequenz, aufweisend:

ein erstes ferroelektrisches "FE"-Material (312b), das auf einer ersten Oberfläche eines Substrats (301) ausgebildet ist,

ein erstes leitfähiges Pad (304b), das auf der ersten Oberfläche des Substrats (301) ausgebildet ist und das erste FE-Material (312b) überlappt,

einen ersten Resonator (302b, 608a), der zwischen dem ersten Filterknoten und einer Erdung gekoppelt ist, wobei der erste Resonator (302b, 608a) an der ersten Oberfläche des Substrats (301) angebracht ist und **durch** eine erste Leitung (305b) mit dem ersten leitfähigen Pad (304b) gekoppelt ist,

ein erstes Kondensator-Pad (306b), das auf der ersten Oberfläche des Substrats (301) ausgebildet ist und das erste FE-Material (312b) überlappt, so dass das erste Kondensator-Pad (306b) von dem ersten leitfähigen Pad (304b) **durch** einen ersten Spaltbereich getrennt ist, so dass ein erster ferroelektrischer "FE"- abstimmbarer Spaltkondensator (610b) gebildet wird, wobei das erste Kondensator-Pad (306b) **durch** einen ersten Gleichstrom-Blockkondensator (341b) mit der Erdung gekoppelt ist,

eine erste Steuerspannung, die mit dem ersten Kondensator-Pad (306b) gekoppelt ist, wobei das erste FE-Material (312b) auf die erste Steuerspannung reagiert, so dass eine erste Kapazität des ersten FE-abstimmbaren Kondensators (610b) und die erste Resonanzfrequenz eingestellt werden,

ein zweites Signalfilter mit einer zweiten Resonanzfrequenz, aufweisend:

ein zweites ferroelektrisches "FE"-Material (312a), das auf der ersten Oberfläche eines Substrats (301) ausgebildet ist,

ein zweites leitfähiges Pad (304a), das auf der ersten Oberfläche des Substrats (301) ausgebildet ist und das zweite FE-Material (312a) überlappt,

einen zweiten Resonator (302a, 604a), der zwischen dem zweiten Filterknoten und der Erdung gekoppelt ist, wobei der zweite Resonator (302a, 604a) an der ersten Oberfläche des Substrats (301) angebracht ist, und **durch** eine zweite Leitung (305a) mit dem zweiten leitfähigen Pad (304a) verbunden ist,

ein zweites Kondensator-Pad (306a), das auf der ersten Oberfläche des Substrats (301) ausgebildet ist und das zweite FE-Material (312a) überlappt, so dass das zweite Kondensator-Pad (306a) von dem zweiten leitfähigen Pad (304a) **durch** einen zweiten Spaltbereich getrennt ist, so dass ein zweiter ferroelektrischer "FE"-abstimmbarer Spaltkondensator (610a) gebildet wird, wobei das zweite Kondensator-Pad (306a) **durch** einen zweiten Gleichstrom-Blockkondensator (341a) mit der Erdung gekoppelt ist,

eine zweite Steuerspannung, die mit dem zweiten Kondensator-Pad (306a) gekoppelt ist, wobei das zweite FE-Material (312a) auf die zweite Steuerspannung reagiert, so dass eine zweite Kapazität des zweiten FE-abstimmbaren Kondensators (610a) und die zweite Resonanzfrequenz angepasst werden, und

einen dritten Kondensator (321, 632a), der zwischen dem ersten Filterknoten und dem zweiten Filterknoten gekoppelt ist.

2. Abstimmbarer Multiplexer (640) gemäß Anspruch 1, wobei der dritte Kondensator (321, 632a) ein dritter FE-abstimmbarer Kondensator ist, der ein drittes ferroelektrisches "FE"-Material aufweist, das auf dem ersten Substrat (301) ausgebildet ist, wobei das erste leitfähige Pad (304b) und das zweite leitfähige Pad (304a) das dritte FE-Material teilweise überlappen und durch einen dritten Spaltbereich getrennt sind, wobei das dritte FE-Material auf ein drittes Steuersignal reagiert, so dass eine dritte Kapazität des dritten FE-abstimmbaren Kondensators angepasst wird.

3. Abstimmbarer Multiplexer (640) gemäß Anspruch 1, wobei ein Gütefaktor des ersten FE-abstimmbaren Kondensators (610b) und des zweiten FE-abstimmbaren Kondensators (610a) größer als einer von ungefähr 80, ungefähr 180 und ungefähr 350 ist.

4. Abstimmbarer Multiplexer (640) gemäß Anspruch 1, wobei ein Gütefaktor des ersten FE-abstimmbaren Kondensators (610b) und des zweiten FE-abstimmbaren Kondensators (610a), wenn er in einem Temperaturbereich von zwischen ungefähr -50 Grad Celsius und 100 Grad Celsius betrieben wird, größer ist als ungefähr 80 in einem von einem ersten Frequenzbereich zwischen 0,25 GHz und 7,0 GHz, einem zweiten Frequenzbereich zwischen ungefähr 0,8 GHz und 7,0 GHz, einem dritten Frequenzbereich zwischen ungefähr 0,25 GHz und 2,5 GHz, und einem vierten Frequenzbereich zwischen ungefähr 0,8 GHz und 2,5 GHz.

5. Abstimmbarer Multiplexer (640) gemäß Anspruch 1, wobei ein Gütefaktor des ersten FE-abstimmbaren Kondensators (610b) und des zweiten FE-abstimmbaren Kondensators (610a), wenn er in einem Temperaturbereich zwischen ungefähr -50 Grad Celsius und 100 Grad Celsius betrieben wird, größer ist als ungefähr 180 in einem von einem ersten Frequenzbereich zwischen ungefähr 0,25 GHz und 7,0 GHz und einem zweiten Frequenzbereich zwischen ungefähr 0,8 GHz und 2,5 GHz.

6. Abstimmbarer Multiplexer (640) gemäß Anspruch 1, wobei ein Gütefaktor des ersten FE-abstimmbaren Kondensators (610b) und des zweiten FE-abstimmbaren Kondensators (610a), wenn er in einem Temperaturbereich zwischen ungefähr -50 Grad Celsius und 100 Grad Celsius betrieben wird, größer ist als ungefähr 80 für eine von einer ersten Kapazität in einem Bereich zwischen ungefähr 0,3 pF und 3,0 pF und einer zweiten Kapazität in einem Bereich zwischen ungefähr 0,5 pF und 1,0 pF.

7. Abstimmbarer Multiplexer (640) gemäß Anspruch 1, wobei ein Gütefaktor des ersten FE-abstimmbaren Kondensators (610b) und des zweiten FE-abstimmbaren Kondensators (610a), wenn er in einem Temperaturbereich zwischen ungefähr -50 Grad Celsius und 100 Grad Celsius betrieben wird, größer ist als ungefähr 180 für eine von einer ersten Kapazität in einem Bereich zwischen ungefähr 0,3 pF und 3,0 pF und einer zweiten Kapazität in einem Bereich zwischen ungefähr 0,5 pF und 1,0 pF.

8. Abstimmbarer Multiplexer (640) gemäß Anspruch 1, wobei:

   die erste Resonanzfrequenz zwischen einem Bereich von ungefähr 1850 MHz bis ungefähr 1910 MHz liegt, und die zweite Resonanzfrequenz zwischen einem Bereich von ungefähr 1930 MHz bis ungefähr 1990 MHz liegt.

9. Abstimmbarer Multiplexer (640) gemäß Anspruch 1, wobei:

   die erste Resonanzfrequenz zwischen einem Bereich von ungefähr 1750 MHz bis ungefähr 1780 MHz liegt, und die zweite Resonanzfrequenz zwischen einem Bereich von ungefähr 1840 MHz und ungefähr 1870 MHz liegt.

10. Abstimmbarer Multiplexer (640) gemäß Anspruch 1, ferner aufweisend:

    ein zweites abstimmbares Filter (646) mit einem dritten Filterknoten, der mit dem ersten Anschluss (642) gekoppelt ist, und mit einem vierten Filterknoten, der mit einem dritten Eingangs-/ Ausgangs- (I/O)-Anschluss gekoppelt ist, aufweisend:

       ein drittes Signalfilter mit einer dritten Resonanzfrequenz, aufweisend:

          ein viertes ferroelektrisches "FE"-Material, das auf der ersten Oberfläche des Substrats (301) ausgebildet ist,
          ein drittes leitfähiges Pad, das auf der ersten Oberfläche des Substrats (301) ausgebildet ist und das vierte FE-Material überlappt,
          einen dritten Resonator (604b), der zwischen dem dritten Filterknoten und der Erdung gekoppelt ist, wobei der dritte Resonator (604b) an der ersten Oberfläche des Substrats (301) angebracht ist und durch eine dritte Leitung mit dem dritten leitfähigen Pad gekoppelt ist,
          ein drittes Kondensator-Pad, das auf der ersten Oberfläche des Substrats (301) ausgebildet ist und das vierte FE-Material überlappt, so dass das dritte Kondensator-Pad von dem dritten leitfähigen Pad durch einen vierten Spaltbereich getrennt ist, so dass ein vierter ferroelektrischer "FE"-abstimmbarer Kondensator (610c) gebildet wird, der zwischen dem dritten Filterknoten und einem dritten geerdeten Gleichstrom-Blockkondensator gekoppelt ist,
          eine vierte Steuerspannung, die mit dem dritten Kondensator-Pad gekoppelt ist, wobei das vierte FE-Material auf die vierte Steuerspannung reagiert, so dass eine vierte Kapazität des vierten FE-abstimmbaren Kondensators (610c) und die dritte Resonanzfrequenz eingestellt werden,

       ein viertes Signalfilter mit einer vierten Resonanzfrequenz, aufweisend:

          ein fünftes ferroelektrisches "FE"-Material, das auf der ersten Oberfläche des Substrats (301) ausgebildet ist,
          ein viertes leitfähiges Pad, das auf der ersten Oberfläche des Substrats (301) ausgebildet ist und das fünfte FE-Material überlappt,

einen vierten Resonator (608b), der zwischen dem vierten Filterknoten und der Erdung gekoppelt ist, wobei der vierte Resonator (608b) an der ersten Oberfläche des Substrats (301) angebracht ist und durch eine vierte Leitung mit dem vierten leitfähigen Pad verbunden ist,

ein viertes Kondensator-Pad, das auf der ersten Oberfläche des Substrats (301) ausgebildet ist und das fünfte FE-Material überlappt, so dass das vierte Kondensator-Pad von dem vierten leitfähigen Pad durch einen fünften Spaltbereich getrennt ist, so dass ein fünfter ferroelektrischer "FE"-abstimmbarer Kondensator (610d) gebildet wird, der zwischen dem vierten Filterknoten und einem vierten geerdeten Gleichstrom-Blockkondensator gekoppelt ist,

eine fünfte Steuerspannung, die mit dem vierten Kondensator-Pad gekoppelt ist, wobei das fünfte FE-Material auf die fünfte Steuerspannung reagiert, so dass eine fünfte Kapazität des fünften FE-abstimmbaren Kondensators (610d) und die vierte Resonanzfrequenz eingestellt werden, und

einen sechsten abstimmbaren Kondensator (632b), der zwischen dem dritten Filterknoten und dem vierten Filterknoten gekoppelt ist.

11. Abstimmbarer Multiplexer (640) gemäß Anspruch 10, wobei das erste abstimmbare Filter (644) ein Senderfilter ist, und das zweite abstimmbare Filter (646) ein Empfängerfilter ist.

12. Abstimmbarer Multiplexer (640) gemäß Anspruch 1, wobei der erste Resonator (608a) als ein erster volumetrischer Resonator aufgebaut ist und wobei der zweite Resonator (604a) als ein zweiter volumetrischer Resonator aufgebaut ist.

13. Abstimmbarer Multiplexer (640) gemäß Anspruch 10, wobei jeder Resonator von dem ersten Resonator (608a), dem zweiten Resonator (604a), dem dritten Resonator (604b) und dem vierten Resonator (608b) einen von einem Streifenleitungsresonator, einem Monoblockresonator und einem koaxialen dielektrischen geladenen Resonator aufweist.

14. Abstimmbarer Multiplexer (640) gemäß Anspruch 10, wobei ein Gütefaktor von jedem Kondensator (610a, 610b, 610c, 610d) größer als eines von ungefähr 80, ungefähr 180 und ungefähr 350 ist.

15. Abstimmbarer Multiplexer (640) gemäß Anspruch 10, wobei die dritten Resonanzfrequenz zwischen einem Bereich von ungefähr 1850 MHz bis ungefähr 1910 MHz liegt, und wobei die vierte Resonanzfrequenz zwischen einem Bereich von ungefähr 1930 MHz bis ungefähr 1990 MHz liegt.

16. Abstimmbarer Multiplexer (640) gemäß Anspruch 10, wobei:

das erste abstimmbare Filter (644) Frequenzen zwischen einem Bereich von ungefähr 1850 MHz bis ungefähr 1910 MHz aussendet, und wobei
das zweite abstimmbare Filter (646) Frequenzen zwischen einem Bereich von ungefähr 1930 MHz bis ungefähr 1990 MHz empfängt.

17. Abstimmbarer Multiplexer (640) gemäß Anspruch 10, wobei der sechste abstimmbare Kondensator (632b) ein sechster FE-abstimmbarer Kondensator ist, der ein sechstes ferroelektrisches (FE)-Material aufweist, das zwischen leitfähigen Pads des sechsten FE-abstimmbaren Kondensators angeordnet ist, wobei das sechste FE-Material auf ein sechstes Steuersignal reagiert, so dass eine sechste Kapazität des sechsten FE-abstimmbaren Kondensators eingestellt wird.

18. Drahtlose Kommunikationsvorrichtung, aufweisend:

den abstimmbaren Multiplexer (640) gemäß Anspruch 11,
eine Batterie,
einen Transceiver,
eine Benutzerschnittstelle, und
ein Gehäuse, das die Batterie und den Transceiver umgibt und so vorgesehen ist, dass es die Benutzerschnittstelle außen an dem Gehäuse darstellt.

**Revendications**

1. Multiplexeur ajustable (640) couplé à une antenne par le biais d'un premier port (642), comprenant un premier filtre ajustable (300, 644) ayant un premier noeud de filtre couplé au premier port (642) et un second noeud de filtre couplé à un second port d'entrée sortie (E/S), **caractérisé par** :

   - un premier filtre de signaux possédant une première fréquence de résonance et comprenant :

      - un premier matériau ferro-électrique « FE » (312b) formé sur une première surface d'un substrat (301) ;
      - une première plage conductrice (304b) formée sur la première surface du substrat (301) et chevauchant le premier matériau FE (312b) ;
      - un premier résonateur (302b, 608a) connecté entre le premier noeud de filtre et la terre, lequel premier résonateur (302b, 608a) est fixé à la première surface du substrat (301) et est connecté par un premier conducteur (305b) à la première plage conductrice (304b) ;
      - une première plage de condensateur (306b) formée sur la première surface du substrat (301) et chevauchant le premier matériau FE (312b) de sorte que la première plage de condensateur (306b) est séparée de la première plage conductrice (304b) par une première zone d'espace afin de former un premier condensateur à espace ajustable ferro-électrique FE (610b), la première plage de condensateur (306b) étant connectée à la terre par le biais d'un premier condensateur de blocage CC (314b) ;
      - une première tension de commande couplée à la première plage de condensateur (306b), le premier matériau FE (312b) réagissant à la première tension de commande afin d'ajuster une première capacitance du premier condensateur ajustable FE (610b) et la première fréquence de résonance ;

   - un second filtre de signaux possédant une seconde fréquence de résonance et comprenant :

      - un second matériau ferro-électrique « FE » (312a) formé sur la première surface d'un substrat (301) ;
      - une seconde plage conductrice (304a) formée sur la première surface du substrat (301) et chevauchant le second matériau FE (312a) ;
      - un second résonateur (302a, 604a) connecté entre le second noeud de filtre et la terre, lequel second résonateur (302a, 604a) est fixé à la première surface du substrat (301) et est connecté par un second conducteur (305a) à la seconde plage conductrice (304a) ;
      - une seconde plage de condensateur (306a) formée sur la première surface du substrat (301) et chevauchant le second matériau FE (312a) de sorte que la seconde plage de condensateur (306a) est séparée de la seconde plage conductrice (304a) par une seconde zone d'espace afin de former un second condensateur à espace ajustable ferro-électrique FE (610a), la seconde plage de condensateur (306a) étant connectée à la terre par le biais d'un second condensateur de blocage CC (314a) ;
      - une seconde tension de commande couplée à la seconde plage de condensateur (306a), le second matériau FE (312a) réagissant à la seconde tension de commande afin d'ajuster une seconde capacitance du second condensateur ajustable FE (610a) et la seconde fréquence de résonance ; et

   - un troisième condensateur (321, 632a) connecté entre le premier noeud de filtre et le second noeud de filtre.

2. Multiplexeur ajustable (640) selon la revendication 1, dans lequel le troisième condensateur (321, 632a) est un troisième condensateur ajustable FE comprenant un troisième matériau ferro-électrique « FE » formé sur le premier substrat, dans lequel la première plage conductrice (304b) et la seconde plage conductrice (304a) chevauchent partiellement le troisième matériau FE et sont séparées par une troisième zone d'espace, le troisième matériau FE réagissant à un troisième signal de commande afin d'ajuster une troisième capacitance du troisième 'condensateur ajustable FE.

3. Multiplexeur ajustable (640) selon la revendication 1, dans lequel un facteur de qualité du premier condensateur ajustable FE (610b) et du second condensateur ajustable FE (610a) est supérieur à environ 80 ou environ 180 ou environ 350.

4. Multiplexeur ajustable (640) selon la revendication 1, dans lequel un facteur de qualité du premier condensateur ajustable FE (610b) et du second condensateur ajustable FE (610a), lorsqu'ils fonctionnent dans une plage de température d'environ -50 degrés Celsius à 100 degrés Celsius, est supérieur à environ 80 dans une plage de fréquence parmi une première plage de fréquence d'environ 0,25 GHz à 7,0 GHz, une seconde plage de fréquence d'environ 0,8 GHz à 7,0 GHz, une troisième plage de fréquence d'environ 0,25 GHz à 2,5 GHz, et une quatrième plage de fréquence d'environ 0,8 GHz à 2,5 GHz.

**5.** Multiplexeur ajustable (640) selon la revendication 1, dans lequel un facteur de qualité du premier condensateur ajustable FE (610b) et du second condensateur ajustable FE (610a), lorsqu'ils fonctionnent dans une plage de température d'environ -50 degrés Celsius à 100 degrés Celsius, est supérieur à environ 180 dans une plage de fréquence parmi une première plage de fréquence d'environ 0,25 GHz à 7,0 GHz et une seconde plage de fréquence d'environ 0,8 GHz à 2,5 GHz.

**6.** Multiplexeur ajustable (640) selon la revendication 1, dans lequel un facteur de qualité du premier condensateur ajustable FE (610b) et du second condensateur ajustable FE (610a), lorsqu'ils fonctionnent dans une plage de température d'environ -50 degrés Celsius à 100 degrés Celsius, est supérieur à environ 80 pour une capacitance parmi une première capacitance dans une plage d'environ 0,3 pF à 3,0 pF, et une seconde capacitance dans une plage d'environ 0,5 pF à 1,0 pF.

**7.** Multiplexeur ajustable (640) selon la revendication 1, dans lequel un facteur de qualité du premier condensateur ajustable FE (610b) et du second condensateur ajustable FE (610a), lorsqu'ils fonctionnent dans une plage de température d'environ -50 degrés Celsius à 100 degrés Celsius, est supérieur à environ 180 pour une capacitance parmi une première capacitance dans une plage d'environ 0,3 pF à 3,0 pF, et une seconde capacitance dans une plage d'environ 0,5 pF à 1,0 pF.

**8.** Multiplexeur ajustable (640) selon la revendication 1, dans lequel :

- la première fréquence de résonance se situe dans une plage d'environ 1850 MHz à environ 1910 MHz ; et
- la seconde fréquence de résonance se situe dans une plage d'environ 1930 MHz à environ 1990 MHz.

**9.** Multiplexeur ajustable (640) selon la revendication 1, dans lequel :

- la première fréquence de résonance se situe dans une plage d'environ 1750 MHz à environ 1780 MHz; et
- la seconde fréquence de résonance se situe dans une plage d'environ 1840 MHz à environ 1870 MHz.

**10.** Multiplexeur ajustable (640) selon la revendication 1, comprenant en outre:

- un second filtre ajustable (646) comprenant un troisième noeud de filtre couplé au premier port (642) et un quatrième noeud de filtre couplé à un troisième port d'entrée sortie (E/S), comprenant :
- un troisième filtre de signaux possédant une troisième fréquence de résonance et comprenant :

  - un quatrième matériau ferro-électrique « FE » formé sur la première surface du substrat (301) ;
  - une troisième plage conductrice formée sur la première surface du substrat (301) et chevauchant le quatrième matériau FE ;
  - un troisième résonateur (604b) connecté entre le troisième noeud de filtre et la terre, lequel troisième résonateur (604b) est fixé à la première surface du substrat (301) et est connecté par un troisième conducteur à la troisième plage conductrice ;
  - une troisième plage de condensateur formée sur la première surface du substrat (301) et chevauchant le quatrième matériau FE de sorte que la troisième plage de condensateur est séparée de la troisième plage conductrice par une quatrième zone d'espace afin de former un quatrième condensateur ajustable ferro-électrique FE (610c) connecté entre le troisième noeud de filtre et un troisième condensateur de blocage CC connecté à la terre ;
  - une quatrième tension de commande couplée à la troisième plage de condensateur, le quatrième matériau FE réagissant à la quatrième tension de commande afin d'ajuster une quatrième capacitance du quatrième condensateur ajustable FE (610c) et la troisième fréquence de résonance ;

- un quatrième filtre de signaux possédant une quatrième fréquence de résonance et comprenant :

  - un cinquième matériau ferro-électrique « FE » formé sur la première surface du substrat (301) ;
  - une quatrième plage conductrice formée sur la première surface du substrat (301) et chevauchant le cinquième matériau FE;
  - un quatrième résonateur (608b) connecté entre le quatrième noeud de filtre et la terre, lequel quatrième résonateur (608b) est fixé à la première surface du substrat (301) et est connecté par un quatrième conducteur à la quatrième plage conductrice ;

- une quatrième plage de condensateur formée sur la première surface du substrat (301) et chevauchant le cinquième matériau FE de sorte que la quatrième plage de condensateur est séparée de la quatrième plage conductrice par une cinquième zone d'espace afin de former un cinquième condensateur ajustable ferro-électrique FE (610d) connecté entre le quatrième noeud de filtre et un quatrième condensateur de blocage CC connecté à la terre ;

- une cinquième tension de commande couplée à la quatrième plage de condensateur, le cinquième matériau FE réagissant à la cinquième tension de commande afin d'ajuster une cinquième capacitance du cinquième condensateur ajustable FE (610d) et la quatrième fréquence de résonance ; et

- un sixième condensateur ajustable (632b) connecté entre le troisième noeud de filtre et le quatrième noeud de filtre.

**11.** Multiplexeur ajustable (640) selon la revendication 10, dans lequel le premier filtre ajustable (644) consiste en un filtre émetteur tandis que le second filtre ajustable (646) consiste en un filtre récepteur.

**12.** Multiplexeur ajustable (640) selon la revendication 1, dans lequel le premier résonateur (608a) se présente sous forme d'un premier résonateur volumétrique, tandis que le second résonateur (604a) se présente sous forme d'un second résonateur volumétrique.

**13.** Multiplexeur ajustable (640) selon la revendication 10, dans lequel chaque résonateur parmi le premier résonateur (608a), le second résonateur (604a), le troisième résonateur (604b) et le quatrième résonateur (608b) comprend un résonateur parmi un résonateur ruban, un résonateur monobloc et un résonateur à charge diélectrique coaxial.

**14.** Multiplexeur ajustable (640) selon la revendication 10, dans lequel un facteur de qualité de chaque condensateur (610a, 610b, 610c, 610d) est supérieur à environ 80 ou environ 180 ou environ 350.

**15.** Multiplexeur ajustable (640) selon la revendication 10, dans lequel la troisième fréquence de résonance se situe dans une plage d'environ 1850 MHz à environ 1910 MHz, tandis que la quatrième fréquence de résonance se situe dans une plage d'environ 1930 MHz à environ 1990 MHz.

**16.** Multiplexeur ajustable (640) selon la revendication 10, dans lequel:

- le premier filtre ajustable (644) émet des fréquences dans une plage d'environ 1850 MHz à environ 1910 MHz ;
- le second filtre ajustable (646) émet des fréquences dans une plage d'environ 1930 MHz à environ 1990 MHz.

**17.** Multiplexeur ajustable (640) selon la revendication 10, dans lequel le sixième condensateur ajustable (632b) consiste en un sixième condensateur ajustable FE comprenant un sixième matériau ferro-électrique (FE) disposé entre les plages conductrices du sixième condensateur ajustable FE, le sixième matériau FE réagissant à un sixième signal de commande afin d'ajuster une sixième capacitance du sixième condensateur ajustable FE.

**18.** Dispositif de communication sans fil comprenant:

- le multiplexeur ajustable (640) selon la revendication 11 ;
- une batterie ;
- un émetteur-récepteur ;
- une interface utilisateur ; et
- un boîtier recevant la batterie et l'émetteur-récepteur, et conçu pour présenter l'interface utilisateur à l'extérieur du boîtier.

**FIG. 1a**

**FIG. 1b**

**FIG. 2a**

FIG. 2b

FIG. 2c

FIG. 3

FIG. 4

**FIG. 5**

**FIG. 6**

FIG. 7

FIG. 8a

**FIG. 8b**

**FIG. 9**

VDC

R1

R2

FIG. 10

437a

437b

301

300

302a

302b

305a

321

305b

320a

304a

304b

320b

315a

310a

310b

315b

D

312a

312b

340a

306a

340b

306b

341a

341b

VDC

VDC

FIG. 11a

301    304a    321    304b

320a    315a    FIG. 11b    315b    320b

640

644    642    646

661    632a    651a    651b    632b    671

604a    604b

610a    608a    610b    610c    608b    610d

FIG. 12

FIG. 13

FIG. 14

FIG. 15

FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 0843374 A

**Non-patent literature cited in the description**

• **S. TONCICH ; R.E. COLLIN.** Data Reduction Method for Q Measurements of Strip-Line Resonators. *IEEE Transactions in MTT,* September 1992, vol. 40 (9), 1833-1836